(19)

**Europäisches Patentamt**

**European Patent Office**

**Office européen des brevets**

(11) **EP 3 809 304 A1**

(12) **EUROPÄISCHE PATENTANMELDUNG**

(43) Veröffentlichungstag:
**21.04.2021 Patentblatt 2021/16**

(51) Int Cl.:
***G06F 30/17*** *(2020.01)*

(21) Anmeldenummer: **19204207.5**

(22) Anmeldetag: **18.10.2019**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **Carl Zeiss Vision International GmbH**
**73430 Aalen (DE)**

(72) Erfinder:
• **SCHWARZ, Oliver**
**73479 Ellwangen (DE)**
• **Eichert, Armin**
**73479 Ellwangen (DE)**

(74) Vertreter: **Gauss, Nikolai et al**
**Pfiz/Gauss Patentanwälte PartmbB**
**Tübingerstraße 26**
**70178 Stuttgart (DE)**

(54) **COMPUTERIMPLEMENTIERTES VERFAHREN ZUR ERMITTLUNG EINES PARAMETRISCHEN ERSATZMODELLS EINES BRILLENFASSUNGSELEMENTS SOWIE VORRICHTUNG UND SYSTEME, DIE EIN SOLCHES VERFAHREN BENUTZEN**

(57) Die Erfindung betrifft ein Verfahren (10) zur Ermittlung eines parametrischen Ersatzmodells eines Brillenfassungselements (24) zu einem parametrischen Modell des Brillenfassungselements (24) zur Anpassung dieses parametrischen Ersatzmodells an den Kopf eines Brillenträgers. Dabei wird wenigstens eine Basisinstanz (38) bereitgestellt durch Erstellen wenigstens einer Instanz (30) des parametrischen Modells des Brillenfassungselements (24) in Form einer Realisierung des parametrischen Modells des wenigstens einen Brillenfassungselements (24) anhand einer Menge von konkreten Parameterwerten. Zu der wenigstens einen Basisinstanz (38) wird wenigstens eine parametrische Deformationsabbildung ermittelt, welche die wenigstens eine Basisinstanz (38) auf Instanzen (30) des parametrischen Modells abbildet, wobei das parametrische Ersatzmodell zumindest aus der wenigstens einen Basisinstanz (38) und aus der wenigstens einen parametrischen Deformationsabbildung bestimmt wird. Alternativ kann zu dem parametrischen Modell des Brillenfassungselements eine Menge von Segmenten bestimmt werden. Zu jedem Segment werden wenigstens eine Basis-Segment-Instanz sowie wenigstens eine parametrische Deformationsabbildung ermittelt. Die wenigstens eine parametrische Deformationsabbildung bildet dann wenigstens eine Basis-Segment-Instanz auf weitere Segment-Instanzen des parametrischen Modells ab, wobei das parametrische Ersatzmodell zumindest aus der Menge von Segmenten sowie aus der wenigstens einen Basis-Segment-Instanz und der wenigstens einen parametrischen Deformationsabbildung für jedes Segment aus der Menge von Segmenten bestimmt wird.

Fig.3

**Beschreibung**

Die Erfindung betrifft ein computerimplementiertes Verfahren zur Ermittlung eines wenigstens einen Parameter aufweisenden parametrischen Ersatzmodells zu einem parametrischen Modell eines Brillenfassungselements. Die Erfindung betrifft außerdem eine Vorrichtung zur Individualisierung und Anpassung eines parametrischen Modells eines Brillenfassungselements an den Kopf eines Brillenträgers sowie eine Vorrichtung zur Darstellung und/oder Kompression einer gegebenen Instanz eines parametrischen Modells eines Brillenfassungselements. Darüber hinaus betrifft die Erfindung ein Computerprogrammprodukt mit einem Computerprogramm mit Programmcode zur Durchführung des Verfahrens sowie ein System mit einer Einrichtung zum Herstellen eines individualisierten Brillenfassungselements oder zum Einschleifen von Brillengläsern in ein individualisiertes Brillenfassungselement.

Zentriermessgeräte für Brillenfassungselemente ermöglichen mittlerweile eine vollautomatische, computergesteuerte Zentriermessung sowie die Individualisierung eines als parametrisches Modell vorliegenden Brillenfassungselements und dessen Anpassung an den Kopf eines Brillenträgers. Hierzu werden Teile des Kopfes des Brillenträgers mit einem 3D-Scanning-Verfahren vermessen und das hierbei erzeugte Kopfmodell in dem Arbeitsspeicher oder dem Festplattenspeicher einer Rechnereinheit hinterlegt. Zur Anpassung an das Kopfmodell des Brillenträgers werden vorzugsweise die Ausdehnung und/oder die Ausrichtung des Brillenfassungselements oder von Teilen dieses sowie Abstände und/oder Winkel zwischen dessen Teilen derart verändert, dass das Brillenfassungselement der Geometrie des Kopfmodells entspricht.

Die Brillenfassungselemente liegen meist als parametrische Modelle, z. B. als CAD-Modelle, in einem bestimmten programmspezifischen Datenformat, z. B. als STL-, STEP-, OBJ- oder PLY-Datei, im Speicher der Rechnereinheit vor. Zur Erzeugung derartiger Modelle können Modellierungs-Programme, z. B. CAD-Programme wie "Creo", "SolidWorks", "Autodesk", "FreeCAD" oder "O-penSCAD", verwendet werden.

Diese Modellierungs-Programme enthalten jedoch in der Regel keine Funktionalität zur Anpassung eines parametrischen Modells eines Brillenfassungselements an ein Kopfmodell. Stattdessen können lediglich Instanzen des parametrischen Modells des Brillenfassungselements erzeugt und abgespeichert werden. Für die Individualisierung und Anpassung von Brillenfassungselementen sind solche Instanzen jedoch nicht geeignet, da diese keine Parameter enthalten und somit nicht verändert und an das Kopfmodell des Brillenträgers angepasst werden können.

Die anhand eines Modellierungs-Programms erzeugten parametrischen Modelle sind aus den folgenden Gründen auch nicht zur Verwendung in einem von dem Modellierungs-Programm unabhängigen System, z. B. einem Anpassungs-System für Brillenfassungselemente, geeignet:
Modellierungs-Programme bieten zum einen in der Regel nicht die Möglichkeit, das einem Brillenfassungselement zu Grunde liegende parametrische Modell zu exportieren und abzuspeichern. Denn die von den Modellierungs-Programmen verwendeten Darstellungsformate für parametrische Modelle sind meist nur für die interne Darstellung und Verarbeitung der Daten innerhalb des jeweiligen Modellierungs-Programms ausgelegt - nicht jedoch für die Verwendung in einem von dem Modellierungs-Programm unabhängigen System. In der Regel sind zum anderen die innerhalb eines Modellierungs-Programms verwendeten Verfahren zur Darstellung und Verwendung der parametrischen Modelle nicht der Öffentlichkeit zugänglich, sodass die parametrischen Modelle ohne weitere Informationen nicht verwendet werden können.

Zur Individualisierung und Anpassung von Brillenfassungselementen ist es deshalb notwendig, parametrische Modelle auch außerhalb des Modellierungs-Programms verfügbar zu machen. Dafür kann ein sogenanntes Reverse Engineering Verfahren verwendet werden, das zu einem gegebenen parametrischen Modell ein von dessen Modellierungs-Programm unabhängiges parametrisches Ersatzmodell erzeugt. Dabei ist es insbesondere wichtig, den zeitintensiven Prozess der Erzeugung von veränderbaren parametrischen Ersatzmodellen zu einem gegebenen Grundmodell möglichst weit zu automatisieren.

Ein Verfahren zur Ermittlung eines parametrischen Ersatzmodells aus einem parametrischen Modell ist aus der WO 2019/051243 A1 bekannt. Dieses Verfahren umfasst die folgenden Schritte:

- Bereitstellen einer Instanz eines CAD-Element-Modells,

- Identifizierung eines oder mehrerer geometrischer Merkmale des CAD-Modells, z. B. Löcher, Flansche, Röhren, Wände, Spannungs- oder Belastungsregionen etc. sowie deren Modifikation anhand von Regeln und Templates;

- Automatische Erstellung eines parametrischen Ersatzmodells auf Basis der geometrischen Merkmale mit geometrischen Parametern wie z. B. Breite, Höhe, Dicke, Durchmesser etc.;

- Berechnung einer modifizierten Instanz des CAD-Modells anhand einer Auswahl der geometrischen Merkmale und zugehöriger Parameterwerte.

Die automatische Identifizierung eines oder mehrerer geometrischer Merkmale in Form von Löchern, Flanschen, Röhren, Wänden etc. sowie deren Modifikation erfolgt dabei anhand zuvor festzulegender Regeln und Templates. Für die einzelnen spezifischen Merkmale müssen dafür jeweils Erkennungsroutinen programmiert und für die Modifikation der einzelnen Merkmale geometrische Parameter festgelegt werden. Da das angegebene Verfahren nicht auf Brillenfassungselemente spezialisiert ist, bedeutet die Definition der Erkennungsroutinen und Parameter für jedes Merkmal eines Brillenfassungselements einen erheblichen Aufwand für den Programmierer. Zusätzlich kann diese Maßnahme leicht zu unrealistischen parametrischen Ersatzmodellen führen, da die Definition des parametrischen Ersatzmodells nicht datengetrieben erfolgt, sondern anhand von durch den Programmierer festgelegten Regeln und Templates. Des Weiteren werden nur einzelne geometrische Merkmale des Modells detektiert und parametrisiert, sodass nur diese veränderbar sind und nicht das gesamte Objekt. Das berechnete parametrische Modell liegt zudem in dem gleichen Datenformat vor wie das Grundmodell, sodass die Verwendung des Ersatzmodells von dem Modellierungs-Programm abhängig ist.

Aus diesen Gründen eignet sich das Verfahren nicht zur Individualisierung und Anpassung von komplexen Modellen mit vielen verschiedenen geometrischen Merkmalen, wie z. B. Brillenfassungselementen, in einem Anpassungs-System.

Aus der Veröffentlichung "Vukašinovic, Nikola & Duhovnik, Joze, CAD Model Creation from Dense Pointclouds: Explicit, Parametric, Free-Form CAD and Re-engineering, Buchtitel: Advanced CAD Modeling, Springer-Verlag 2019, S.217-239" ist ein Verfahren bekannt, das ein Objekt mit Freiformflächen in Form von NURBS automatisch aus Punktewolken rekonstruiert. Dabei wird jedoch kein den Punktewolken zu Grunde liegendes parametrisches Modell generiert.

In der Veröffentlichung "Automatic and Parametric Mesh Generation Approach, Alan M Shih, Sankarappan Gopalsamy, Yasushi Ito, Douglas Ross, Mark Dillavou, Bharat Soni, 2005" ist ein Verfahren beschrieben, das anhand von Parameteränderungen und Simulationen eine optimierte Geometrie eines parametrischen Modells für einen gegebenen Anwendungszweck erzeugt. Für importierte Objektgeometrien ist jedoch kein automatisches Verfahren verfügbar.

In der Veröffentlichung "Development of Parametric Mesh Morphing Techniques, Makoto Onodera, Ichiro Nishigaki, Yoshimitsu Hiro, Chikara Kongo, Transactions of the Japan Society of Mechanical Engineers Series C. 74, 2008, S. 1894-1600" ist ein Verfahren beschrieben, das geometrische Merkmale eines Meshs in Form von ebenen Flächen, Quadriken oder Freiformflächen identifiziert.

In der US 2016/0327811 A1 ist ein Verfahren zur Anpassung von Brillenfassungen beschrieben. Die Brillenfassungen liegen hier allerdings nicht als parametrisches Modell vor, das anhand seiner Parameter verändert wird, sondern werden direkt deformiert. Dabei sind lediglich elastische Deformationen vorgesehen. Auch eine Änderung der Materialmenge ist nicht möglich.

Die US 2016/336737 A1 beschreibt die Anpassung einer Brillenfassung anhand eines parametrisierbaren Fassungsmodells. Ein parametrisches Brillenfassungsmodell wird hier jedoch nicht aus einem gegebenen parametrischen Brillenfassungsmodell erzeugt.

In der EP 2 746 838 A1 ist zwar ein Anpassungs-System für virtuelle Brillenfassungen beschrieben, das auf einem parametrischen Modell der Brillenfassung basiert. Dieses parametrische Modell wird aber direkt auf Basis von Raumkurven und umschlossenen Volumina verändert und dient nicht der Erzeugung eines parametrischen Ersatzmodells.

Die vorstehenden Verfahren erlauben es daher nicht, aus einem gegebenen parametrischen Modell ein parametrisches Ersatzmodell weitgehend automatisch zu erzeugen.

Aufgabe der Erfindung ist es deshalb, eine weitgehend automatische Ermittlung eines wenigstens einen Parameter aufweisenden parametrischen Ersatzmodells zu einem parametrischen Modell eines Brillenfassungselements zu ermöglichen.

Diese Aufgabe wird durch das in Anspruch 1 sowie das in Anspruch 2 angegebene Verfahren gelöst. Vorteilhafte Ausführungsformen und Weiterbildungen der Erfindung sind in den abhängigen Ansprüchen angegeben.

Das in Anspruch 1 angegebene erfindungsgemäße computerimplementierte Verfahren zur Ermittlung eines wenigstens einen Parameter aufweisenden parametrischen Ersatzmodells zu einem parametrischen Modell wenigstens eines Brillenfassungselements umfasst die folgenden Verfahrensschritte:

Vorgeben mehrerer Instanzen des parametrischen Modells, Ermitteln wenigstens einer Basisinstanz und wenigstens einer parametrischen Deformationsabbildung zu der wenigstens einen Basisinstanz aus den vorgegebenen Instanzen, wobei die wenigstens eine parametrische Deformationsabbildung die wenigstens eine Basisinstanz auf Instanzen des parametrischen Modells abbildet. Das parametrische Ersatzmodell wird dabei zumindest aus der wenigstens einen Basisinstanz und aus der wenigstens einen parametrischen Deformationsabbildung bestimmt.

Ein Brillenfassungselement bezeichnet vorliegend einen Teil einer Brillenfassung wie z. B. einen Fassungsbügel, eine Nasenauflagefläche, eine Brücke, ein Anschlusselement oder ein Fassungsvorderteil. Ein Brillenfassungselement kann aber auch eine Kombination von Brillenfassungselementen darstellen oder Abschnitte eines Brillenfassungselements, z. B. einen Fassungsbügelabschnitt, oder auch die gesamte Brillenfassung.

Unter einem parametrischen Modell sowie einem parametrischen Ersatzmodell eines Brillenfassungselements versteht die Erfindung eine dreidimensionale Darstellung eines Brillenfassungselements in einer Rechnereinheit, die wenigstens einen Parameter zur Anpassung von Merkmalen und/oder Eigenschaften des Brillenfassungselements oder Teilen dieses, z. B. der Bügellänge oder der Anstellwinkel der Nasenauflageflächen enthält.

Ein parametrisches Modell für ein Brillenfassungselement kann z. B. als CAD-Modell vorliegen. Unter einem CAD-Modell ist vorliegend eine mittels einer Rechnereinheit verarbeitbare Repräsentation von 3D-Objekten zu verstehen, die insbesondere in die Rechnereinheit eingelesen und in dieser z. B. als Datei in einen Festplattenspeicher der Rechnereinheit abgespeichert werden kann.

Ein parametrisches Ersatzmodell ist ein parametrisches Modell, welches anstatt eines anderen parametrischen Modells in einem Prozess, wie z. B. der Individualisierung und Anpassung von Brillenfassungselementen, verwendet wird und somit das andere parametrische Modell (Grundmodell) ersetzt.

Parameter bezeichnen dabei veränderliche Werte, anhand welcher die Merkmale und/oder Eigenschaften des Brillenfassungselements oder Teile dieses beeinflusst werden können. Parameterwerte bezeichnen die für diese Parameter einsetzbaren konkreten Zahlenwerte.

Unter einer Instanz eines parametrischen Modells bzw. eines parametrischen Ersatzmodells versteht die Erfindung ein spezielles Exemplar in Form einer Realisierung des parametrischen Modells bzw. des parametrischen Ersatzmodells für ausgewählte Parameterwerte. Dabei wird jedem Parameter des parametrischen Modells bzw. parametrischen Ersatzmodells ein Parameterwert zugeordnet.

Unter einer Basisinstanz versteht die Erfindung eine spezielle Instanz eines parametrischen Modells, die ausgewählt oder berechnet wird, und die zur Definition einer parametrischen Deformationsabbildung verwendet wird.

Eine parametrische Deformationsabbildung ist eine Abbildung mit Parametern, welche auf die Oberfläche einer gegebenen Basisinstanz wirkt, z. B. eine affine Abbildung mit Parametern. Durch Auswahl spezifischer Parameterwerte für die Parameter der Abbildung kann eine konkrete Abbildung erzeugt werden, welche die Oberfläche der Basisinstanz verändert. Auf diese Weise wird (gegebenenfalls bei Festlegen der weiteren Parameterwerte für die Parameter des parametrischen Ersatzmodells) eine Instanz des parametrischen Ersatzmodells erzeugt.

Der Erfindung liegt die Idee zu Grunde, dass durch das Vorgeben mehrerer Instanzen des parametrischen Modells ein höherer Grad der Automatisierung durch eine datengetriebene Ermittlung des parametrischen Ersatzmodells erzielt werden kann. Aus der Mehrzahl von Instanzen können nämlich automatisch Teile des parametrischen Ersatzmodells wie die wenigstens eine Basisinstanz, die parametrischen Deformationsabbildungen oder auch eine Zerlegung des parametrischen Modells in Segmente berechnet werden. Dabei ist es von Vorteil, wenn die vorgegebenen Instanzen die Variabilität des parametrischen Modells des Brillenfassungselements möglichst gut abbilden. Bei Verwendung einer einzigen Instanz als Ausgangspunkt erfordern diese Schritte einen sehr viel größeren Programmieraufwand, da der Programmierer Routinen zur automatischen Erkennung einzelner Brillenfassungselemente sowie zur Veränderung dieser Brillenfassungselemente anhand parametrischer Deformationsabbildungen selbst erstellen muss. Durch Vorgeben mehrerer Instanzen des parametrischen Modells können stattdessen automatisierte Verfahren, z. B. Verfahren des maschinellen Lernens, verwendet werden, um das parametrische Ersatzmodell möglichst automatisch anhand der vorgegebenen Instanzen zu erzeugen.

Der Erfindung liegt außerdem die Idee zu Grunde, dass durch die Verwendung mehrerer Instanzen bei der Berechnung des parametrischen Ersatzmodells die Qualität des parametrischen Ersatzmodells - im Sinne einer möglichst hohen Ähnlichkeit der von dem parametrischen Modell und dem parametrischen Ersatzmodell erzeugbaren Instanzen - verbessert werden kann, da nicht-datengetriebene, d. h. vom Programmierer festgelegte, Erkennungsroutinen zur Identifizierung einzelner Merkmale fehleranfällig sind.

Schließlich kann anhand der Mehrzahl von Instanzen ein parametrisches Ersatzmodell bestimmt werden, das es erlaubt, das gesamte Objekt zu verändern - nicht nur einzelne detektierte geometrische Merkmale.

Das in Anspruch 2 angegebene erfindungsgemäße computerimplementierte Verfahren zur Ermittlung eines wenigstens einen Parameter aufweisenden parametrischen Ersatzmodells zu einem parametrischen Modell wenigstens eines Brillenfassungselements umfasst die folgenden Verfahrensschritte:

Vorgeben mehrerer Instanzen des parametrischen Modells;

Bestimmen einer Menge von Segmenten zu dem parametrischen Modell des Brillenfassungselements,

Zerlegen der vorgegebenen Instanzen in die Segmente aus der Menge von Segmenten;

Erzeugung von Segment-Instanzen zu jedem Segment aus der Menge von Segmenten, indem Instanzen dieses Segments aus den zerlegten vorgegebenen Instanzen ausgewählt werden;

Ermitteln wenigstens einer Basis-Segment-Instanz und wenigstens einer parametrischen Deformationsabbildung zu der wenigstens einen Basis-Segment-Instanz aus diesen Segment-Instanzen.

Dabei bildet die wenigstens eine parametrische Deformationsabbildung die wenigstens eine Basis-Segment-Instanz auf Segment-Instanzen des parametrischen Modells ab. Das parametrische Ersatzmodell wird zumindest aus der Menge von Segmenten sowie aus der wenigstens einen Basis-Segment-Instanz und der wenigstens einen parametrischen Deformationsabbildung für jedes Segment aus der Menge von Segmenten bestimmt.

Hier wird also zu jedem Segment in einem computerimplementierten Verfahren ein wenigstens einen Parameter aufweisendes parametrisches Ersatzmodell als Segment-Ersatzmodell bestimmt, wobei als vorgegebene Instanzen dabei die zu einem jeden Segment gehörenden Segment-Instanzen verwendet werden.

Segmente sind dabei Teilmengen eines Brillenfassungselements, z. B. Teile des Fassungsvorderteils oder Teile des Fassungsbügels. Liegt nur ein Brillenfassungselement vor, z. B. in Form der gesamten Brillenfassung, so kann die Menge der Segmente z. B. die Brücke, die Fassungsbügel oder Anschlussstellen enthalten.

Eine Segment-Instanz bezeichnet eine Instanz eines Segments eines parametrischen Modells bzw. parametrischen Ersatzmodells.

Eine Basis-Segment-Instanz bezeichnet eine Basisinstanz eines Segments eines parametrischen Modells bzw. parametrischen Ersatzmodells. Sie wird aus ausgewählten Segment-Instanzen zu diesem Segment bestimmt. Der erfindungsgemäßen Idee von Anspruch 2 liegt der Gedanke zu Grunde, dass eine höhere Qualität und eine höhere Flexibilität des parametrischen Ersatzmodells erzielt werden kann, indem das parametrische Modell des Brillenfassungselements in Segmente zerlegt wird und zu jedem Segment einzeln wenigstens eine Basis-Segment-Instanz und wenigstens eine parametrische Deformationsabbildung bestimmt werden. Dadurch kann nämlich das parametrische Ersatzmodell besonders gut an die Besonderheiten des jeweiligen Segments angepasst werden, anstatt die Deformationen der wenigstens einen Basis-Segment-Instanz des gesamten parametrischen Modells abzubilden. Diese Maßnahme ermöglicht eine höhere Variabilität und Anpassbarkeit des parametrischen Ersatzmodells. Zusätzlich ermöglicht dies auch eine Verringerung der Komplexität der wenigstens einen Basis-Segment-Instanz sowie der parametrischen Deformationsabbildungen und damit des parametrischen Ersatzmodells. Auch die Bestimmung von Parameterwerten für die Parameter des parametrischen Ersatzmodells wird durch ein parametrisches Ersatzmodell geringerer Komplexität vereinfacht, was Rechenzeit einspart.

Die wenigstens eine Basisinstanz bzw. die Basis-Segment-Instanz kann dabei aus den vorgegebenen Instanzen bzw. den Segment-Instanzen ausgewählt oder berechnet werden, z. B. durch Ermitteln des Mittelwerts.

Brillenfassungselemente können beispielweise anhand von Meshes oder Punktewolken in Rechnereinheiten dargestellt werden. Vorzugsweise liegen diese Objekte als Meshes vor. Ansonsten kann zunächst mittels Triangulierung ein Mesh, z. B. aus einer gegebenen Punktewolke, erzeugt werden.

Meshes sind insbesondere Dreiecksnetze, die Oberflächenpunkte in Form von Knotenpunkten, Normalenvektoren an den Knotenpunkten und Dreiecksflächen umfassen. Eine kontinuierliche Darstellung eines solchen Dreiecksnetzes kann anhand von Shading-Algorithmen erzeugt werden.

Neben der Darstellung anhand von Dreiecksnetzen existieren auch andere polygonale oder volumenbasierte Darstellungsformen von Meshes, wie z. B. in dem Wikipedia-Artikel "Types of Meshes" vom 11.07.2019 erläutert (https://en.wikipedia.org/wiki/Types of mesh). Zweidimensionale Meshes können z. B. aus dreiecksförmigen oder auch viereckigen Zellen aufgebaut sein. Dreidimensionale Meshes können aus pyramidenförmigen, quaderförmigen oder prismenförmigen Zellen bestehen.

Anhand des parametrischen Ersatzmodells zu einem Brillenfassungselement und einer gegebenen Menge von Parameterwerten für die Parameter des parametrischen Ersatzmodells kann eine Instanz des parametrischen Ersatzmodells des Brillenfassungselements erzeugt werden. Diese enthält eine Menge von Oberflächenpunkten in Form von 3D-Punkten auf der Oberfläche des wenigstens einen Brillenfassungselements.

Es können Wahrscheinlichkeitsverteilungen oder Wertebereiche zu Parametern eines parametrischen Modells bzw. eines parametrischen Ersatzmodells gegeben sein oder ermittelt werden. Ein Wertebereich ist dabei durch einen minimalen und einen maximalen Wert begrenztes Kontinuum von Parameterwerten. Alternativ kann er auch als eine Menge diskreter Parameterwerte vorliegen, z. B. durch Abtastung eines kontinuierlichen Wertebereichs zwischen Minimal- und Maximalwert, beispielsweise in äquidistanten Schritten. Ist eine Wahrscheinlichkeitsverteilung zu einem Parameter gegeben, so ist es zweckmäßig Parameterwerte mit höherer Wahrscheinlichkeit auszuwählen. Anhand einer vorgegebenen Menge von Instanzen des parametrischen Modells bzw. des parametrischen Ersatzmodells können auch Wertebereiche oder Wahrscheinlichkeitsverteilungen für die Parameter des Modells ermittelt werden.

Unter einer Wahrscheinlichkeitsverteilung zu einem Parameter eines parametrischen Modells bzw. parametrischen Ersatzmodells ist vorliegend eine Beschreibung der Häufigkeit zu verstehen, mit der einzelne Parameterwerte bei der Erzeugung unterschiedlicher Instanzen vorkommen. Ist der Wert der Wahrscheinlichkeitsverteilung für einen bestimmten Wert eines Parameters groß, so bedeutet das, dass der Wert dieses Parameters für viele Instanzen typisch ist. Ist dagegen der Wert der Wahrscheinlichkeitsverteilung für einen bestimmten Parameter klein oder geht der Wert der Wahrscheinlichkeitsverteilung für einen bestimmten Parameter gegen Null, so bedeutet das, dass der Wert dieses Parameters für eine große Zahl von Instanzen nicht vorkommt.

Das Ermitteln von Wertebereichen und/oder Wahrscheinlichkeitsverteilungen zu Parametern verbessert die Handhabbarkeit des parametrischen Ersatzmodells für den Anwender, da Parameterwerte, die unrealistische oder nicht gewünschte Instanzen erzeugen, von Vornherein ausgeschlossen werden.

Die Erzeugung von Instanzen anhand von Wertebereichen oder Wahrscheinlichkeitsverteilungen für die Parameter des parametrischen Modells kann automatisch, z. B. durch Auswahl des Mittelwerts, Medians oder Erwartungswertes erfolgen. Alternativ können Parameterwerte auch manuell über eine Bedienoberfläche vom Anwender ausgewählt werden.

Anpassungen eines parametrischen Modells eines Brillenfassungselements können mittels parametrischer-Abbildungen bewirkt werden, die z. B. auf sämtliche Oberflächenpunkte oder auf Teilmengen der Oberflächenpunkte des Meshs des Brillenfassungselements angewendet werden. Durch Anpassung der Werte aller oder einzelner Parameter dieser Abbildungen kann das Brillenfassungselement modifiziert werden.

Bei einer gegebenen Instanz eines parametrischen Modells bzw. eines parametrischen Ersatzmodells bewirkt eine Änderung eines Parameterwertes eine Änderung der Oberflächenpunkte der Instanz.

Das parametrische Ersatzmodell kann die gleichen Parameter wie das parametrische Modell enthalten oder es kann andere Parameter, zusätzliche Parameter oder nur eine Teilmenge der Parameter des parametrischen Modells enthalten.

Das parametrische Ersatzmodell kann die folgenden Elemente enthalten, die jeweils Parameter aufweisen können:

- die Menge von Segmenten;
- die Anzahl der Segmente;
- die wenigstens eine Basisinstanz bzw. Basis-Segment-Instanz als Mesh;
- die wenigstens eine Basisinstanz bzw. Basis-Segment-Instanz in Form eines Index, der die ausgewählte Basisinstanz bzw. Basis-Segment-Instanz innerhalb der vorgegebenen Instanzen bzw. Segment-Instanzen kennzeichnet;
- eine Rechenvorschrift, die es erlaubt, die wenigstens eine Basisinstanz bzw. Basis-Segment-Instanz zu bestimmen, insbesondere anhand der vorgegebenen Instanzen bzw. Segment-Instanzen, z. B. durch Berechnen des Mittelwerts der vorgegebenen (gegebenenfalls normierten) Instanzen bzw. Segment-Instanzen;
- die wenigstens eine parametrische Deformationsabbildung;
- zusätzliche Merkmale wie Ohrauflagepunkte, Nasenauflagepunkte, Auflagekurven der Enden der Fassungsbügel, 3D-Glasebenen als Approximation für die in die Brillenfassung einzupassenden Gläser, 3D-Boxen zur Approximation der Fassungsränder des Fassungsvorderteils, Nasenpads;
- eine Nachverarbeitungsroutine;
- Wertebereiche und/oder Wahrscheinlichkeitsverteilungen über die Parameterwerte des parametrischen Ersatzmodells.

Damit das parametrische Ersatzmodell als Ersatz für ein parametrisches Modell nutzbar ist, ist es von Vorteil, wenn die Qualität des parametrischen Ersatzmodells möglichst hoch ist, d. h. dass zu jeder Instanz des parametrischen Modells eine Instanz des parametrischen Ersatzmodells derart erzeugt werden kann, dass die Abweichung der beiden Instanzen möglichst gering ist.

Die Abweichung von zwei Instanzen kann auf Basis ihrer Oberflächenpunkte bestimmt werden. Sie kann als ein Kriterium aus der Gruppe umfassend gewichtete Summe, Durchschnitt, Maximum oder Quantile der Verteilung der kleinsten Abweichungen zwischen der Oberfläche, z. B. den Oberflächenpunkten, der einen Instanz und der Oberfläche der anderen Instanz berechnet werden. Die Abweichung zwischen zwei Instanzen kann z. B. als einseitige Haussdorff-Distanz oder zweiseitige Haussdorff-Distanz bestimmt werden, so wie dies z. B. in N. ASPERT, D. SANTA-CRUZ, T. EBRAHIMI, MESH: Measuring Errors between Surfaces using the Hausdorff Distance, Proceedings IEEE International Conference on Multimedia and Expo Lausanne, Switzerland (2002) auf den Seiten 1 bis 4 beschrieben ist, worauf hiermit Bezug genommen und wobei die Offenbarung dieser Publikation in die Beschreibung dieser Erfindung einbezogen wird.

Die einseitige Haussdorff-Distanz h entspricht dem Maximum aller kleinsten Abstände $d\colon \mathbb{R}^3 \times \mathbb{R}^3 \to \mathbb{R}$ der einen Instanz S von der anderen Instanz S', z. B. dem Maximum der Euklidischen Distanzen der Oberflächenpunkte der einen Instanz S von dem jeweils nächstliegenden Oberflächenpunkt der anderen Instanz S':

$$h(S,S') = \max_{p\in S}\ \min_{p'\in S'} d(p,p').$$

Die zweiseitige Haussdorff-Distanz H(S,S') beschreibt demgegenüber das Maximum der beiden einseitigen Haussdorff-Distanzen zwischen den Oberflächen S und S':

$$H(S, S') = max\{\max_{p \in S} \min_{p' \in S'} d(p, p'), \max_{p' \in S'} \min_{p \in S} d(p, p')\}$$

Alternativ zu den Abweichungen zwischen Oberflächenpunkten der Instanzen können auch Abweichungen zwischen den Oberflächen selbst bestimmt werden, z. B. anhand der Dreiecke der Meshes oder anhand der mittels eines Skelettierungsverfahrens bestimmten Skelette der Instanzen.

Zur Messung der Qualität eines parametrischen Ersatzmodells eines Brillenfassungselements können Gütekriterien für das parametrische Ersatzmodell des Brillenfassungselements anhand einer Menge A von Instanzen des parametrischen Modells des Brillenfassungselements, z. B. der vorgegebenen Instanzen und/oder weiterer nicht zur Erzeugung des parametrischen Ersatzmodells verwendeter Instanzen, und einer Menge B von Instanzen des parametrischen Ersatzmodells des Brillenfassungselements definiert werden. Die Menge B umfasst dabei zu jeder Instanz der Menge A eine anhand des parametrischen Ersatzmodells des Brillenfassungselements erzeugte Instanz mit möglichst geringer Abweichung zwischen den Oberflächen.

Ein Gütekriterium kann dabei einen kontinuierlichen Wertebereich aufweisen, z. B. in Form der maximalen oder durchschnittlichen Abweichung der Instanzen der Menge A und der Instanzen der Menge B.

Alternativ kann auch ein binärwertiges Gütekriterium verwendet werden, das entweder erfüllt oder nicht erfüllt ist. Ein derartiges Gütekriterium kann z. B. in Form von Bedingungen formuliert sein, die ein parametrische Ersatzmodell erfüllen muss, um den Qualitätsanforderungen des Anwenders zu genügen. Zum Beispiel können für verschiedene Bereiche des parametrischen Modells des Brillenfassungselements maximal zulässige Abweichungen festgelegt werden, die zwischen Instanzen der Menge A und Instanzen der Menge B in den vorgegebenen Bereichen auftreten dürfen. Beispielsweise kann für die Oberflächen im Bereich der Nasenauflageflächen eine maximal zulässige Abweichung von 0,05 mm und für Oberflächen im Bereich der Fassungsbügel eine maximale Abweichung von 0.5 mm festgelegt werden.

Unter einer Optimierung eines kontinuierlichen Gütekriteriums versteht die Erfindung dessen Maximierung bzw. Minimierung durch Anpassung der Elemente des parametrischen Ersatzmodells des wenigstens einen Brillenfassungselements, z. B. der wenigstens einen Basisinstanz, der Menge von Segmenten oder der parametrischen Deformationsabbildungen. Unter einer Optimierung eines binärwertigen Gütekriteriums versteht die Erfindung die Anpassung der Parameter des parametrischen Ersatzmodells des wenigstens einen Brillenfassungselements bis die vorgegebenen Bedingungen erfüllt sind.

Für jeden Parameter des parametrischen Ersatzmodells des wenigstens einen Brillenfassungselements kann ein Wertebereich und/oder eine Wahrscheinlichkeitsverteilung über die Parameterwerte bestimmt werden. Dafür können mehrere Instanzen, z. B. die vorgegebenen Instanzen, anhand des parametrischen Ersatzmodells dargestellt werden. Aus den zu den vorgegebenen Instanzen gehörenden Parameterwerten können dann Wertebereiche oder Wahrscheinlichkeitsverteilungen für die Parameter des parametrischen Ersatzmodells ermittelt werden

Ein in einem vorstehend angegebenen Verfahren ermitteltes Ersatzmodell wenigstens eines Brillenfassungselements bietet insbesondere folgende Vorteile: Durch einen hohen Grad an Automatisierung des Verfahrens ist der Aufwand zur Generierung des parametrischen Ersatzmodells des wenigstens einen Brillenfassungselements gering für den Anwender. Insbesondere können hier maschinelle Lernverfahren verwendet werden, die auf Basis der vorgegebenen Instanzen das parametrische Ersatzmodell weitgehend automatisch erzeugen.

Außerdem benötigt das Verfahren nur geringe Rechenzeiten, da die einzelnen Schritte des Verfahrens besonders effizient durchführbar sind. Das Ermitteln der Basisinstanz sowie der parametrischen Deformationsabbildungen kann z. B. einfach durch Auswahl erfolgen.

Zudem ist das erzeugte parametrische Ersatzmodell des wenigstens einen Brillenfassungselements von besonders hoher Qualität in dem Sinne, dass eine anhand des gegebenen parametrischen Modells des Brillenfassungselements erzeugte Instanz mit geringer Abweichung auch anhand des parametrischen Ersatzmodells darstellbar ist. Je geringer die Abweichung ist, desto höher ist die Qualität des parametrischen Ersatzmodells, denn umso besser eignet es sich als Ersatz für das parametrische Modell.

Das erzeugte parametrische Ersatzmodell ist überdies von geringer Komplexität aufgrund seiner Struktur aus feststehenden Basisinstanzen und parametrischen Deformationsabbildungen. Dies ermöglicht eine besonders schnelle Anpassung des parametrischen Ersatzmodells an den Kopf eines Brillenträgers, da die Optimierung eines Systems von geringer Komplexität weniger komplexe Algorithmen zur Optimierung und somit auch weniger Rechenzeit benötigt. Zudem ermöglicht die geringe Komplexität des parametrischen Ersasztmodells eine besonders schnelle Verarbeitung von Parameteränderungen. Denn ein System zur Fassungsindividualisierung findet nur dann Akzeptanz beim Kunden und beim Optiker, wenn während des Anpassungs-Prozesses die Ergebnisse von Parameteränderung sofort am Bildschirm sichtbar sind. Bei komplexen parametrischen Modellen nimmt die Berechnung einer neuen Instanz bei einer Parameteränderung jedoch oft mehrere Sekunden Rechenzeit in Anspruch.

Instanzen des parametrischen Ersatzmodells des wenigstens einen Brillenfassungselements benötigen nur geringen Speicherplatz bei der Darstellung in einem Speicher einer Rechnereinheit. Denn es wird nicht das gesamte Mesh abgespeichert, sondern lediglich die Parameterwerte der Elemente des parametrischen Ersatzmodells, z. B. der Index der ausgewählten Basisinstanz falls mehr als eine Basisinstanz in dem parametrischen Ersatzmodell enthalten ist, oder die Parameterwerte der wenigstens einen parametrischen Deformationsabbildung. Dadurch können Datenbanken mit vielen Brillenfassungsmodellen oder Brillenfassungselementmodellen ohne großen Aufwand abgespeichert werden. Diese Maßnahme reduziert gleichzeitig die Übertragungzeit zwischen Anpassung- und Bestellsystem. Außerdem eignet sich das parametrische Ersatzmodell deshalb auch zur Kompression von Instanzen des parametrischen Modells. Instanzen des parametrischen Modells können nämlich als Instanzen eines parametrischen Ersatzmodells zu dem parametrischen Modell dargestellt werden, wobei lediglich die Parameterwerte zu den Instanzen des parametrischen Ersatzmodells abgespeichert werden müssen anstatt des gesamten Meshs.

Das parametrische Ersatzmodell bietet dem Anwender eine große Flexibilität bei der Erzeugung von Instanzen. Es können nämlich nicht nur Instanzen aus einer vorgegebenen abgespeicherten Menge von Instanzen des parametrischen Modells des Brillenfassungselements ausgewählt werden, sondern Instanzen zu beliebigen Parameterwerten, z. B. Zwischenwerten, erzeugt werden. Sind z. B. Instanzen eines parametrischen Modells eines Fassungsbügels mit unterschiedlichen Längen gegeben, so können anhand des parametrischen Ersatzmodells Instanzen mit weiteren Längen erzeugt werden. Das parametrische Ersatzmodell kann dadurch im Vergleich zu den vorgegebenen Instanzen auch mit höherer Genauigkeit an den Kopf des Brillenträgers angepasst werden.

Aufgrund dieser Vorteile ist das erzeugte parametrische Ersatzmodell des Brillenfassungselements sowie das Verfahren für dessen Generierung für den Anwender komfortabel handhabbar.

Die vorgegebenen Instanzen des parametrischen Modells eines Brillenfassungselements können aus einer Menge von Instanzen des parametrischen Modells ausgewählt werden. Diese Menge kann anhand des Modellier-Systems, in dem das parametrische Modell erzeugt wurde, generiert werden. Anhand dieser Menge von vorgegebenen Instanzen können einzelne Verfahrensschritte optimiert werden, um eine höhere Qualität des parametrischen Ersatzmodells zu gewährleisten.

Dabei ist es von Vorteil, wenn die Menge der vorgegebenen Instanzen mindestens zwei anhand unterschiedlicher Parameterwerte erzeugter Instanzen des parametrischen Modells des Brillenfassungselements enthält. Jede vorgegebene Instanz stellt eine konkrete Realisierung des parametrischen Modells für einen ausgewählten Satz von Parameterwerten dar. Als Parameterwerte können z. B. die Grenzen der Wertebereiche der Parameter oder Mittelwerte oder Mediane dieser ausgewählt werden. Alternativ können die Instanzen auch durch eine zufällige Auswahl von Parameterwerten bestimmt werden.

Sei n die Anzahl der Parameter des parametrischen Modells, dann wird für jeden Parameter eine Anzahl k von Parameterwerten innerhalb des entsprechenden Parameterbereichs ausgewählt. Aus allen Kombinationen dieser Parameterwerte wird eine Menge vorgegebener Instanzen erzeugt, die somit $k^n$ Instanzen enthält. Vorteilhafterweise werden für jeden Parameter k = 2 Parameterwerte ausgewählt, z. B. anhand eines Parameterwertes am oberen und eines am unteren Rand des Wertebereichs des Parameters. Noch vorteilhafter ist eine Anzahl von k = 5 Parameterwerten pro Parameter. Es ist auch möglich, für jeden Parameter eine unterschiedliche Menge von Parameterwerten auszuwählen.

Die vorgegebenen Instanzen liegen vorzugsweise in einem gemeinsamen Koordinatensystem vor, z. B. in dem Koordinatensystem des parametrischen Modells des Brillenfassungselements. Weiter vorzugsweise sind die vorgegebenen Instanzen des parametrischen Modells derart in dem Koordinatensystem positioniert und orientiert, dass der Schwerpunkt der jeweiligen Instanz mit dem Zentrum des Koordinatensystems übereinstimmt. Zusätzlich oder alternativ kann eine Symmetrieebene der jeweiligen Instanz eine oder zwei Achsen des Koordinatensystems enthalten.

Die Ausrichtung kann z. B. anhand einer Hauptkomponentenanalyse berechnet werden, indem die ersten beiden (orthogonalen) Hauptkomponenten der Punkte des Meshs bestimmt und alle Punkte des Meshs so transformiert werden, dass die beiden Hauptkomponenten auf die Koordinatenachsen abgebildet werden, z. B. die erste Hauptkomponente auf die Applikatenachse und die zweite Hauptkomponente auf die Ordinatenachse.

Diese Maßnahmen zur Ausrichtung haben den Vorteil, dass das parametrische Ersatzmodell von möglichst hoher Qualität ist und dass dessen Erzeugung möglichst wenig Rechenzeit benötigt und möglichst automatisiert durchgeführt werden kann.

Die Generierung der vorgegebenen Instanzen kann anhand eines Computerprogramms automatisiert erfolgen, was Rechenzeit und Aufwand für den Anwender spart. Außerdem trägt diese Maßnahme zu einem hohen Grad an Automatisierung des Verfahrens bei.

Es ist von Vorteil, wenn die vorgegebenen Instanzen des parametrischen Modells wenigstens teilweise mittels eines Algorithmus zur Ausbesserung von Fehlern und/oder zur Verbesserung des visuellen Eindrucks für den Brillenträger und/oder zur Glättung nachverarbeitet werden. Fehler können z. B. topologische Fehler wie Löcher oder eine unregelmäßige Triangulierung sein, z. B. eine unregelmäßige Dichte oder Größe der Oberflächendreiecke des Meshs. Anhand dieses Vorverarbeitungsschritts lässt sich eine höhere Qualität des anhand der vorgegebenen Instanzen erzeugten parametrischen Ersatzmodells erreichen.

Die Elemente des parametrischen Ersatzmodells können anhand der vorgegebenen Instanzen bestimmt werden. Diese Bestimmung kann manuell durch den Programmierer oder Anwender geschehen oder automatisch anhand von maschinellen Lernverfahren. Dabei ist es von Vorteil, dass zur Bestimmung des parametrischen Ersatzmodells, z. B. der wenigstens einen Basisinstanz, der wenigstens einen parametrischen Deformationsabbildung oder der Menge von Segmenten, ein Kriterium aus der Gruppe umfassend gewichtete Summe, Durchschnitt, Maximum und Quantile der Verteilung der Abweichungen zwischen den Oberflächen, z. B. den Oberflächenpunkten, der vorgegebenen Instanzen des parametrischen Modells und den Oberflächen aller anhand konkreter Parameterwerte erzeugbarer Instanzen des parametrischen Ersatzmodells des wenigstens einen Brillenfassungselements optimiert.

Zudem ist es von Vorteil, wenn bei der Zerlegung von Instanzen des parametrischen Modells des Brillenfassungselements in Segmente aus der Menge von Segmenten ein Verfahren zur Erkennung von Wendepunkten in Signalen und/oder ein Mesh-Segmentierungsverfahren und/oder multivariate Anpassungs-Verfahren und/oder Skelettierungsverfahren und/oder ein maschinelles Lernverfahren angewendet wird.

Zur automatischen Zerlegung von Instanzen des parametrischen Modells des Brillenfassungselements in Segmente aus der Menge von Segmenten anhand eines Verfahrens zur Detektion von Wendepunkten werden die Oberflächenpunkte der Instanz entlang einer Raumachse auf eine Ebene projiziert. Aus den Projektionspunkten kann anhand eines Algorithmus eine Teilmenge ausgewählt werden, deren Urbild zu einer Kontur eines Brillenfassungselements gehört. Diese Teilmenge von Projektionspunkten kann als eine Folge diskreter Abtastwerte eines Signals verstanden werden. Mittels eines Algorithmus können dann Wendepunkte dieses Signals bestimmt werden. Anhand dieser Wendepunkte werden schließlich die Grenzen der Segmente aus der Menge von Segmenten bestimmt.

Dieses Vorgehen hat den Vorteil, dass die Zerlegung der Instanzen vollständig automatisiert erfolgen kann. Denn der Algorithmus zur Detektion von Wendepunkten benötigt keine semantischen Informationen über die Beschaffenheit der einzelnen Segmente oder deren Grenzen oder darüber, wie diese in den Daten gefunden werden können. Dadurch verringert sich der Aufwand für den Anwender erheblich.

Alternativ dazu können auch maschinelle Lernverfahren zur automatischen Zerlegung von Instanzen in Segmente aus der Menge von Segmenten verwendet werden.

Alternativ können auch andere Mesh-Segmentierungsverfahren, wie in dem Artikel ″A Survey on Mesh Segmentation Techniques, Ariel Shamir, Computer Graphics Forum, Band 27, Ausgabe 6, 2008, S. 1839 - 1856″ beschrieben, verwendet werden. Auch multivariate Anpassungs-Methoden, wie in dem Buch ″Using Multivariate Statistics, Barbara G. Tabachnick, Linda S. Fidell, Jodie B. Ullman, Pearson Verlag, 2007″ dargestellt, können eingesetzt werden.

Alternativ dazu können auch Skelettierungsverfahren wie in dem Artikel ″Skeleton Extraction by Mesh Contraction, Oscar Kin-Chung Au, Chiew-Lan Tai, Hung-Kuo Chu, Daniel Cohen-Or, Tong-Yee Lee, Proceedings of SIGGRAPH 2008″ beschrieben, zur Segmentierung von Instanzen dienen.

Auf das zuvor genannte Buch und die beiden Artikel wird hiermit vollumfänglich Bezug genommen und deren Offenbarungsgehalt in die Beschreibung dieser Erfindung mit einbezogen.

Anhand eines Skelettierungsverfahrens kann z. B. zu dem Mesh einer Instanz eine Struktur von geringerer Komplexität in Form eines Skeletts erzeugt werden. Das Skelett eines dreidimensionalen Objekts umfasst dabei alle inneren Punkte des Objekts, die Mittelpunkt einer maximalen, in dem Objekt enthaltenen Kugel sind.

Jeder Oberflächenpunkt der Instanz kann dann einem nächstliegenden Punkt des erzeugten Skeletts zugeordnet werden. Anstatt des Meshs der Instanz kann nun das weniger komplexe Skelett dieser Instanz in Regionen zerlegt werden. Alle zu einer Region des Skeletts gehörenden Oberflächenpunkte bilden dann ein Segment. Diese Vorgehensweise spart Rechenzeit.

Ein weiterer Vorteil ist, dass das erzeugte Skelett auch in dem folgenden Verfahrensschritt zur Bestimmung der parametrischen Deformationsabbildungen herangezogen werden kann. Denn die Abbildung einer Instanz auf eine andere anhand der zugehörigen Skelette spart ebenfalls Aufwand und Rechenzeit.

Die wenigstens eine parametrische Deformationsabbildung dient zur Abbildung einer Basisinstanz bzw. einer Basis-Segment-Instanz auf weitere Instanzen bzw. entsprechende Segment-Instanzen des parametrischen Modells des wenigstens einen Brillenfassungselements. Die parametrischen Deformationsabbildungen werden dabei in Form von Funktionen mit zu bestimmenden Parametern festgelegt.

Als parametrische Deformationsabbildungen können beispielsweise affine Abbildungen, die eine Rotation, eine Translation und eine Skalierung der Segmente beschreiben, gewählt werden.

Von Vorteil ist es, wenn die parametrischen Deformationsabbildungen des parametrischen Ersatzmodells aus der Gruppe umfassend affine Abbildungen, Polynome, polynomiale Flächen, Bezier-Kurven, Splines oder NURBS stammen. Dadurch kann eine höhere Qualität des parametrischen Ersatzmodells sowie eine geringe Rechenzeit bei der Darstellung oder Anpassung von Brillenfassungselementen an den Kopf erreicht werden.

Gleichzeitig kann z. B. durch Wahl von parametrischen Deformationsabbildungen geringer Komplexität mit wenigen Parametern, wie z. B. affinen Abbildungen, der Automatisierungsgrad des Verfahrens gesteigert werden. In diesem Fall können die Parameterwerte der parametrischen Deformationsabbildungen nämlich automatisch anhand eines Algorithmus zur Minimierung der Abweichung zwischen Instanzen des parametrischen Modells und des parametrischen Ersatzmodells bestimmt werden.

Es können außerdem maschinelle Lernverfahren verwendet werden, um die Elemente des parametrischen Ersatzmodells, insbesondere die wenigstens eine Basisinstanz und die wenigstens eine parametrische Deformationsabbildung zu bestimmen. Vorzugsweise kann hier eine Hauptkomponentenanalyse zum Einsatz kommen. Dafür werden die vorgegebenen Instanzen als Punktewolken oder Voxelgitter dargestellt. Diese können als Vektor repräsentiert werden, der z. B. die Koordinaten der Punkte enthält oder für jeden Voxel eine Information, ob dieser innerhalb oder außerhalb des Brillenfassungselements liegt. Anhand der vektorisierten vorgegebenen Instanzen des parametrischen Modells kann zuerst der Mittelwert der vorgegebenen Instanzen bestimmt werden. Dieser bildet dann die Basisinstanz. Von den vorgegebenen Instanzen kann jeweils der Mittelwert abgezogen und daraus die Kovarianzmatrix der Instanzen berechnet werden. Durch Diagonalisierung dieser können die Eigenvektoren und Eigenwerte der Kovarianzmatrix bestimmt werden. Um eine geringere Komplexität des parametrischen Ersatzmodells zu erreichen, können nur Eigenvektoren zu großen Eigenwerten ausgewählt werden. Die vorgegebenen Instanzen sowie weitere Instanzen I des parametrischen Modells bzw. deren Segmente lassen sich nun näherungsweise durch parametrische Deformationsabbildungen in Form einer Linearkombination der Basisinstanz b als Mittelwert und der n Eigenvektoren $v_i$ darstellen:

$$I = f(b, \alpha) = b + \sum_{i=1}^{n} \alpha_i v_i$$

Das parametrische Ersatzmodell besteht dann aus der Basisinstanz b und den Eigenvektoren $v_i$. Zur Darstellung einer spezifischen Instanz anhand des parametrischen Ersatzmodells werden dann die Parameterwerte $\alpha_i$ der parametrischen Deformationsabbildungen bestimmt. Auch neuronale Netze können zur automatischen Berechnung der Basisinstanz und der Deformationsabbildungen verwendet werden.

Vorzugsweise wird das parametrische Ersatzmodell in dem Speicher einer Rechnereinheit abgespeichert.

Ein Vorteil des Verfahrens ist, dass es auf parametrische Modelle wenigstens eines Brillenfassungselements mit einer Oberfläche von beliebigem Geschlecht anwendbar ist. Das Geschlecht einer Fläche ist definiert als die maximale Anzahl von möglichen Schnitten entlang disjunkter, einfach geschlossener Kurven, so dass die Fläche nach allen gemachten Schnitten noch zusammenhängend ist. Sie bezeichnet somit die Anzahl der Löcher in der Oberfläche. Dies verbessert die Handhabung des Verfahrens für den Anwender, da das Verfahren nicht auf eine Klasse von Brillenfassungselementen von bestimmtem Geschlecht beschränkt ist.

Es ist von Vorteil, wenn die Segmente aus der Menge von Segmenten des parametrischen Ersatzmodells als statisch, beweglich oder deformierbar gekennzeichnet werden.

Die Kennzeichnung kann anhand eines Clustering-Verfahrens automatisch vorgenommen werden, das mittels verschiedener Instanzen des parametrischen Modells des Brillenfassungselements, z. B. der vorgegebenen Instanzen, zusammenhängende Oberflächenpunkte anhand ihrer Bewegung analysiert.

Anhand dieser Kennzeichnung kann die Qualität des parametrischen Ersatzmodells verbessert werden, da die parametrischen Deformationsabbildungen in Abhängigkeit von der Bewegung des jeweiligen Segments passend ausgewählt werden können.

Bei der Auswahl der Segment-Instanzen aus den in Segmente zerlegten vorgegebenen Instanzen ist für als statisch gekennzeichnete Segmente eine Segment-Instanz ausreichend. Für als beweglich oder deformierbar gekennzeichnete Segmente ist es von Vorteil für die Genauigkeit des parametrischen Ersatzmodells, wenn wenigstens zwei Segment-Instanzen, vorzugsweise fünf Segment-Instanzen, vorliegen.

Weiterhin ist es besonders von Vorteil, wenn die parametrischen Deformationsabbildungen der als statisch gekennzeichneten Segmente lineare Abbildungen sind und/oder die parametrischen Deformationsabbildungen der als beweglich gekennzeichneten Segmente affine Abbildungen sind und/oder die parametrischen Deformationsabbildungen der als deformierbar gekennzeichneten Segmente anhand von Polynomen, polynomialen Flächen, Bezier-Kurven, Splines oder NURBS approximiert werden.

Dadurch wird die Komplexität der parametrischen Deformationsabbildungen durch Anpassung an die Bewegung der Segmente verringert. Dies spart Rechenzeit und verbessert die Qualität des parametrischen Ersatzmodells.

Vorzugsweise wird bei Änderungen der Parameter des parametrischen Ersatzmodells eines Brillenfassungselements die Dreiecksstruktur des Meshs, d. h. die Topologie und Vernetzung der Dreiecke, nicht neu berechnet, sondern beibehalten. Dadurch entfällt der zeitintensive Schritt der Triangulierung der Oberflächenpunkte zur Anpassung des Dreiecksnetzes. Dies spart Rechenzeit und führt gleichzeitig zu einem parametrischen Ersatzmodell des Brillenfassungselements von geringerer Komplexität.

Eine vorteilhafte Weiterbildung der Erfindung sieht vor, dass Verfahrensschritte zur Ermittlung des parametrischen Ersatzmodells iteriert werden. Diese Maßnahme gewährleistet eine höhere Qualität des parametrischen Ersatzmodells, da die einzelnen Elemente des parametrischen Ersatzmodells voneinander abhängig sind und auf diese Weise besser optimiert werden können.

Vorteilhafterweise sind die Segmente aus der Menge von Segmenten derart hierarchisch in einer Baumstruktur angeordnet, dass die in der Baumstruktur verbundenen Knoten zu Segmenten mit einer gemeinsamen Schnittkante oder -fläche in dem parametrischen Modell gehören. Miteinander verbundene Knoten des Baums zeigen somit eine räumliche Nachbarschaft der zugehörigen Segmente an.

Weiter ist es von Vorteil, wenn jedes Segment in der Baumstruktur relativ zu seinem Vorgängersegment in einem Koordinatensystem positioniert und orientiert ist. Die Segmente können dabei ein eigenes lokales Koordinatensystem sowie zusätzlich die Position und Orientierung relativ zu dem in der Baumstruktur übergeordneten Segment enthalten. Durch die relative Orientierung der Segmente zueinander ergibt sich in Summe eine Verkettung von Starrkörpertransformationen, anhand der die Basisinstanz zu dem Brillenfassungselement angepasst wird. Die Starrkörpertransformationen können z. B. als kinematische Kette kodiert sein wie in dem Wikipedia-Artikel vom 28.06.2019 zum Thema "Forward Kinematics" beschrieben.

Die hierarchische Anordnung der Segmente vereinfacht die Berechnung der Parameterwerte des parametrischen Ersatzmodells, da diese schrittweise für die einzelnen Knoten entlang der Hierarchie der Baumstruktur und in Abhängigkeit von den berechneten Parameterwerten des Vorgängerknotens bestimmt werden können. Dies spart Rechenzeit und verbessert die Qualität des parametrischen Ersatzmodells.

Bei Vorliegen von wenigstens zwei Brillenfassungselementen können diese zusätzlich oder alternativ zu den Segmenten in einer hierarchischen Baumstruktur angeordnet sein.

Da für jedes Segment der wenigstens einen Basisinstanz des wenigstens einen Brillenfassungselements Parameterwerte unabhängig von den anderen Segmenten bestimmt werden, kann es zu Sprungstellen an den Segmentgrenzen kommen. Zur Verbesserung der Qualität des parametrischen Ersatzmodells und des visuellen Eindrucks für den Brillenträger können Instanzen des parametrischen Ersatzmodells anhand eines Algorithmus zur Vermeidung von Sprungstellen an Segmentgrenzen nachverarbeitet werden. Diese Maßnahme kann in einem zusätzlichen Verfahrensschritt vorgesehen sein.

Der Nachverarbeitungsschritt des parametrischen Ersatzmodells des wenigstens einen Brillenfassungselements kann außerdem einen Algorithmus zur Ausbesserung von Fehlern und/oder zur Verbesserung des visuellen Eindrucks für den Brillenträger und/oder zur Glättung des Meshs enthalten.

Beispielsweise kann ein Glättungsverfahren als Nachverarbeitungsschritt gewählt werden. Die Art des Nachverarbeitungsverfahrens sowie dessen Parameter können bestimmt und zusätzlich in dem parametrischen Ersatzmodell abgespeichert werden.

Von Vorteil ist außerdem die Integration von Symmetrieannahmen bezüglich einzelner Segmente, z. B. des linken und des rechten Fassungsbügels, in das parametrische Ersatzmodell. Beispielsweise genügt es zur Erstellung eines parametrischen Ersatzmodells einer gesamten Brillenfassung aufgrund deren Symmetrie, wenn nur ein parametrisches Ersatzmodell des linken bzw. rechten Fassungsbügels vorhanden ist. Eine Instanz des jeweils anderen Fassungsbügels kann durch Spiegelung an der Symmetrieebene der Brillenfassung und Ausrichtung an dem Fassungsvorderteil ermittelt werden. Anhand dieser Maßnahme kann Rechenzeit und Speicherplatz sowie Übertragungszeit eingespart werden.

Im Falle einer eher geringen Variation des parametrischen Modells eines Brillenfassungselements kann die Komplexität des parametrischen Ersatzmodells des wenigstens einen Brillenfassungselements ebenfalls verringert werden, um Rechenzeit und gegebenenfalls Aufwand für den Anwender einzusparen. Dafür wird eine größere Menge an Basisinstanzen für das parametrische Ersatzmodell des Brillenfassungselements derart ausgewählt, dass diese den Variationsbereich des Brillenfassungselements möglichst gut repräsentiert.

Brillenfassungselemente mit geringer Variation, z. B. die meist lediglich in der Gesamtlänge variierenden Fassungsbügel, können so durch Auswahl aus einer Menge von Basisinstanzen, z. B. einer Menge von Basisinstanzen für verschiedene Bügellängen, direkt ausgewählt werden. Auf diese Weise müssen keine parametrische Deformationsabbildungen ermittelt und deren Parameterwerte anhand von Algorithmen berechnet werden.

Eine vorteilhafte Ausführungsform der Erfindung sieht weiterhin vor, dass zu dem parametrischen Ersatzmodell des Brillenfassungselements zusätzliche Merkmale aus der Gruppe umfassend Ohrauflagepunkte, Nasenauflagepunkte, Auflagekurven der Enden der Fassungsbügel, 3D-Glasebenen, 3D-Boxen, Nasenpads berechnet werden. Diese zusätzlichen Merkmale erleichtern die Anpassung des parametrischen Ersatzmodells des Brillenfassungselements an den Kopf des Brillenträgers anhand bestimmter an dem Kopfmodell des Brillenträgers detektierter Orientierungspunkte. Dies verbessert die Handhabbarkeit des parametrischen Ersatzmodells für den Anwender.

Unter Datenformat versteht die Erfindung die mittels einer Rechnereinheit verarbeitbare Repräsentation von Informationen oder Daten, die insbesondere in die Rechnereinheit eingelesen und in dieser z. B. als Datei in einem Festplattenspeicher der Rechnereinheit abgespeichert werden kann.

Es ist von Vorteil, wenn das parametrische Ersatzmodell in einem Datenformat bereitgestellt wird, das sich von dem des parametrischen Modells unterscheidet, insbesondere in einem Datenformat, das unabhängig von dem System ist, in welchem das parametrische Modell erzeugt wurde. Liegt das parametrische Modell z. B. als CAD-Modell vor, so kann das parametrische Ersatzmodell in einem Datenformat bereitgestellt werden, welches an das spezifische System angepasst ist, in dem das parametrische Ersatzmodell verwendet werden soll, z. B. an das Anpassungs-System zur Anpassung eines Brillenfassungselements an den Kopf eines Brillenträgers.

Die Ermittlung eines parametrischen Ersatzmodells mit einer formatunabhängigen Darstellung wird durch die Vorgabe von Instanzen des parametrischen Modells erleichtert. Das parametrische Modell liegt zwar in einem speziellen Format vor, z. B. in dem Format des vom Designer verwendeten Modellierungs-Programms. Die vorgegebenen Instanzen liegen jedoch als Mesh. Sie sind damit unabhängig von dem Format des Modellierungs-Programms und können in einem anderen Datenformat abgespeichert werden.

Eine vorteilhafte Weiterbildung sieht vor, ein wenigstens einen Parameter aufweisendes parametrisches Ersatzmodell zu einem parametrischen Modell eines Brillenfassungselements in einem computerimplementierten Verfahren zur Individualisierung des Brillenfassungselements durch Anpassung des parametrischen Modells des Brillenfassungselements an den Kopf eines Brillenträgers zu verwenden. Dabei wird in einem ersten Schritt eine Darstellung des Kopfes in einem Koordinatensystem in einer Rechnereinheit bestimmt. Dies kann z. B. durch die Aufnahme des Kopfes aus verschiedenen Aufnahmerichtungen mittels einer Bildverarbeitungseinrichtung und das Berechnen eines 3D-Modells des Kopfes anhand eines 3D-Rekonstruktionsverfahrens erreicht werden. In einem zweiten Schritt wird dann ein Parameterwert für den wenigstens einen Parameter des parametrischen Ersatzmodells des Brillenfassungselements ermittelt, sodass die anhand dieses wenigstens einen Parameterwerts erzeugte Instanz des parametrischen Ersatzmodells des Brillenfassungselements möglichst gut an den Kopf angepasst ist. Für die Berechnung jeweils eines Parametwerts für jeden Parameter des parametrischen Ersatzmodells können Optimierungsverfahren eingesetzt werden. Alternativ kann dieser Schritt auch anhand von Eingaben eines Anwenders über eine Anwenderschnittstelle der Rechnereinheit durchgeführt werden.

Eine andere vorteilhafte Weiterbildung sieht vor, ein wenigstens einen Parameter aufweisendes parametrisches Ersatzmodell zu einem parametrischen Modell eines Brillenfassungselements in einem computerimplementierten Verfahren zur Darstellung und/oder Kompression einer gegebenen Instanz des parametrischen Modells des Brillenfassungselements in einer Rechnereinheit zu verwenden.

Dabei wird in einem ersten Schritt jeweils ein Parameterwert für den wenigstens einen Parameter des parametrischen Ersatzmodells des Brillenfassungselements durch Optimieren eines Kriteriums aus der Gruppe umfassend gewichtete Summe, Durchschnitt, Maximum und Quantile der Verteilung der Abweichungen zwischen Oberflächen, z. B. Oberflächenpunkten, der gegebenen Instanz des parametrischen Modells und Oberflächen, z. B. Oberflächenpunkten, der anhand dieses wenigstens einen Parameterwerts erzeugten Instanz des parametrischen Ersatzmodells ermittelt. Der wenigstens eine ermittelte Parameterwert kann dann in einem Speicher der Rechnereinheit abgespeichert werden.

Dieses Verfahren hat den Vorteil, dass eine gegebene Instanz eines parametrischen Modells des wenigstens einen Brillenfassungselements bei Vorliegen eines parametrischen Ersatzmodells des wenigstens einen Brillenfassungselements anhand sehr weniger Parametwerte repräsentiert werden kann. Dadurch kann eine Instanz sehr speicherplatzsparend abgespeichert werden. Insbesondere bei größeren Mengen an Instanzen in einer Fassungsdatenbank kann auf diese Weise der Speicherbedarf deutlich reduziert werden. Damit einhergehend kann auch aufgrund der geringeren Datenmenge die Übertragungszeit für angepasste Brillenfassungselemente, z. B. zwischen einem Anpassungs-System bei einem Optiker und einem Bestellsystem oder einer privaten Rechnereinheit des Brillenträgers, stark reduziert werden.

In dem Verfahren zur Individualisierung eines parametrischen Modells wenigstens eines Brillenfassungselements und/oder in dem Verfahren zur Darstellung und/oder Kompression sowie bei der Übertragung von Instanzen eines parametrischen Modells eines Brillenfassungselements ist es vorteilhaft, wenn bei der Optimierung des wenigstens einen Parameters des parametrischen Ersatzmodells Abstände zwischen Punktewolken minimiert werden.

In dem Verfahren zur Individualisierung eines parametrischen Modells eines Brillenfassungselements sind die Punktewolken als Oberflächenpunkte der Basisinstanz des parametrischen Ersatzmodells sowie als Oberflächenpunkte des Meshs des Kopfes des Brillenträgers gegeben. In diesem Fall wird z. B. der Abstand zwischen einem Ohrauflagepunkt eines Fassungsbügels und Oberflächenpunkten des Ohrs des Brillenträgers minimiert.

In dem Verfahren zur Darstellung und/oder Kompression von Instanzen eines parametrischen Modells eines Brillenfassungselements sind die Punktewolken als Oberflächenpunkte der ausgewählten Basisinstanz des parametrischen Ersatzmodells des Brillenfassungselements sowie als Oberflächenpunkte der darzustellenden und/oder zu komprimierenden Instanz gegeben. In diesem Fall wird die Abweichung aller Oberflächenpunkte der beiden Instanzen minimiert, z. B. anhand der Haussdorff-Distanz.

Ein Verfahren zur Minimierung von Abständen zwischen Punktewolken ist z. B. der Iterative Closest Point (ICP) Algorithmus, der zusammen mit verschiedenen Varianten in dem Artikel "Efficient Variants of the ICP Algorithm, Szymon Rusinkiewicz, Marc Levoy, Proceedings of the 3DIM Conference, Quebec, 2001, pages 145-182" beschrieben ist, auf den hiermit vollumfänglich Bezug genommen und dessen Offenbarungsgehalt in die Beschreibung dieser Erfindung mit einbezogen wird.

Dieser Algorithmus hat den Vorteil, dass die Parameterwerte des parametrischen Ersatzmodells besonders genau und mit möglichst wenig Aufwand und Rechenzeit bestimmt werden können. Dadurch werden die Qualität und die Handhabbarkeit des parametrischen Ersatzmodells verbessert.

Ein erfindungsgemäßes Computerprogrammprodukt enthält ein Computerprogramm mit Programmcode zur Durchführung der vorstehend angegebenen Verfahrensschritte, wenn das Computerprogramm in eine Rechnereinheit geladen und/oder in einer Rechnereinheit durchgeführt wird.

Eine Vorrichtung zur Individualisierung und Anpassung eines parametrischen Modells eines Brillenfassungselements an den Kopf eines Brillenträgers enthält eine Rechnereinheit, in die ein computerimplementiertes Verfahren zur Anpassung des parametrischen Modells des Brillenfassungselements an eine Darstellung des Kopfes in einem Koordinatensystem geladen ist.

Eine Vorrichtung zur Darstellung und/oder Kompression einer gegebenen Instanz eines parametrischen Modells eines Brillenfassungselements enthält eine Rechnereinheit mit einem Speicher, in die ein computerimplementiertes Verfahren zur Darstellung und/oder Kompression der gegebenen Instanz in dem Speicher der Rechnereinheit geladen ist.

Ein erfindungsgemäßes System mit einer Einrichtung zum Herstellen eines in einem vorstehend angegebenen Verfahren zur Individualisierung eines Brillenfassungselements individualisiertes Brillenfassungselement oder zum Einschleifen von Brillengläsern in ein in einem vorstehend angegebenen Verfahren zur Individualisierung eines Brillenfassungselements individualisiertes Brillenfassungselement verwendet den wenigstens einen ermittelten Parameterwert des parametrischen Ersatzmodells.

Nachfolgend werden vorteilhafte Ausführungsbeispiele der Erfindung beschrieben, die in den Zeichnungen schematisch dargestellt sind.

Es zeigen:

| | |
|---|---|
| Fig. 1 | ein parametrisches Modell eines Brillenfassungselements in Form eines CAD-Modells einer Brillenfassung mit verschiedenen weiteren Brillenfassungselementen; |
| Fig. 2 | ein Mesh eines Brillenfassungselements mit Oberflächenpunkten und einem Dreiecksnetz; |
| Fig. 3 | ein Verfahren zur Ermittlung eines parametrischen Ersatzmodells eines Brillenfassungselements in Form eines Fassungsbügels; |
| Fig. 4 | ein alternatives Verfahren zur Ermittlung eines parametrischen Ersatzmodells eines Brillenfassungselements in Form eines Fassungsvorderteils; |
| Fig 5 | ein Koordinatensystem zur Anordnung von Instanzen anhand deren Schwerpunkt und Symmetrieebene; |
| Fig. 6 | Instanzen eines CAD-Modells eines Fassungsvorderteils und eines Fassungsbügels; |
| Fig. 7 | das Ermitteln einer Basisinstanz eines CAD-Modells eines Fassungsvorderteils anhand vorgegebener Instanzen; |
| Fig. 8 | eine Zerlegung einer Instanz eines CAD-Modells in Segmente aus der Menge von Segmenten; |
| Fig. 9 | das Ermitteln eines parametrischen Ersatzmodells eines CAD-Modells eines Fassungsvorderteils mit einer Basisinstanz und einer parametrischen Deformationsabbildung anhand vorgegebener Instanzen mittels einer Hauptkomponentenanalyse; |
| Fig. 10 | Verfahrensschritte zur Ermittlung eines parametrischen Ersatzmodells eines Brillenfassungselements anhand vorgegebener Instanzen; |
| Fig. 11 | eine Anordnung von Segmenten aus der Menge von Segmenten eines parametrischen Ersatzmodells eines Brillenfassungselements in einer hierarchischen Baumstruktur; |
| Fig. 12 | ein Verfahren zur Individualisierung eines Brillenfassungselements; |

Fig. 13      ein Verfahren zur Darstellung und/oder Kompression einer Instanz eines parametrischen Modells eines Brillenfassungselements;

Fig. 14      Projektionspunkte erzeugt durch Projektion von Oberflächenpunkten eines Meshs eines Fassungsvorderteils in eine Ebene;

Fig. 15      einen oberen und einen unteren Fassungsrand einer Instanz eines CAD- Modells eines Fassungsvorderteils;

Fig. 16      ein Signal bestehend aus Teilsignalen und Wendepunkten;

Fig. 17A, Fig. 17B sowie Fig. 17C      berechnete Wendepunkte und Mittelwerte von Teilsignalen zu projizierten Oberflächenpunkten eines oberen und unteren Brillenfassungsrands;

Fig. 18A, Fig. 18B      eine Zerlegung zweier Instanzen eines parametrischen Ersatzmodells eines Fassungsvorderteils anhand von ermittelten Wendepunkten in Signalen;

Fig. 19      eine Zerlegung einer Instanz eines CAD-Modells eines Fassungsbügels in zwei Segmente;

Fig. 20      die Optimierung der Zerlegung einer Instanz in Segmente durch Variation der Parameterwerte der Segmentierung;

Fig. 21A, Fig. 21B sowie Fig. 21C      die Bestimmung von Parameterwerten einer parametrischen Deformationsabbildung zu einer Basis-Segment-Instanz eines CAD-Modells eines Fassungsbügels und dem entsprechenden Segment einer weiteren Instanz anhand eines ICP-Algorithmus;

Fig. 22A, Fig. 22B sowie Fig. 22C      die Bestimmung von Parameterwerten von parametrischen Deformationsabbildungen zu Basis-Segment-Instanzen eines CAD-Modells eines Fassungsvorderteils und den entsprechenden Segmenten einer weiteren Instanz;

Fig. 23      Verfahrensschritte zur Erzeugung eines Meshs anhand eines parametrischen Ersatzmodells und gegebener Parameterwerte; und

Fig. 24A, Fig. 24B sowie Fig. 24 C      die Glättung einer Instanz eines parametrischen Ersatzmodells eines Anschlusselements anhand eines Nachverarbeitungsschritts zur Glättung an Segmentgrenzen.

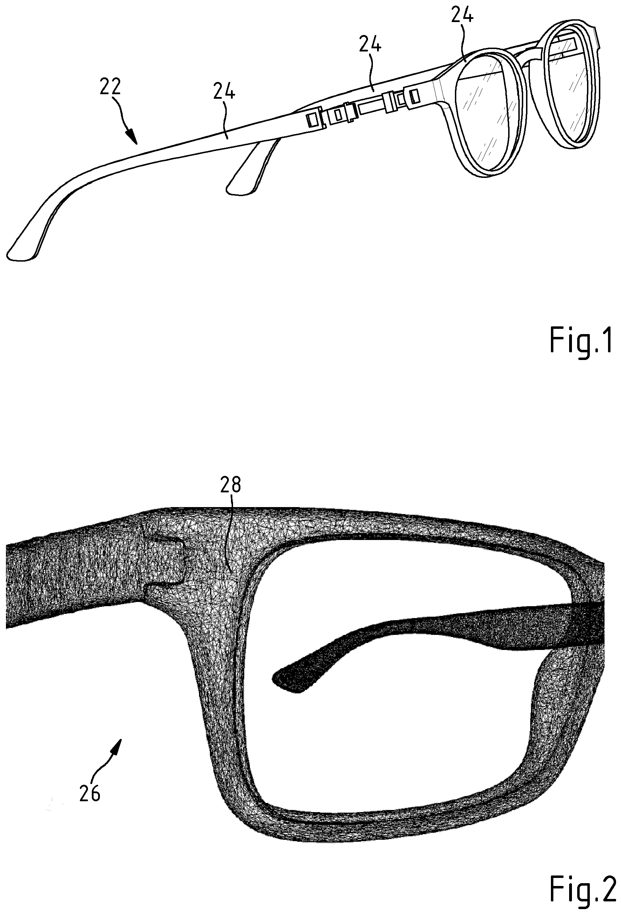

Die Fig. 1 zeigt ein parametrisches Modell eines Brillenfassungselements 24 in Form eines CAD-Modells 22 einer Brillenfassung mit verschiedenen weiteren Brillenfassungselementen 24, unter anderem mit dem Fassungsvorderteil, den Fassungsbügeln und Anschlusselementen.

Sind diese Brillenfassungselemente 24 im CAD-Modell schon markiert, so kann das Brillenfassungselement 24 direkt ausgewählt werden, für das das parametrische Ersatzmodell bestimmt werden soll. Liegen keine Markierungen einzelner Brillenfassungselemente 24 vor oder ist dies nicht gewünscht, so kann das parametrische Ersatzmodell für die gesamte Brillenfassung ermittelt werden.

Für das Verfahren ist es nicht notwendig, dass das parametrische Modell des Fassungsherstellers selbst vorliegt - eine Menge von Instanzen 30 ist ausreichend.

Instanzen 30 des CAD-Modells 22 liegen vorzugsweise als Mesh 26 vor. Die Fig. 2 zeigt das Mesh 26 eines Brillenfassungselements 24. Die Oberfläche des Meshs 26 besteht aus Dreiecken, die anhand von Oberflächenpunkten 28 in Form von Punkten auf der Oberfläche des Brillenfassungselements 24 definiert sind. Die Instanzen 30 können z. B. als Meshes 26 in einer Datenbank 42 abgespeichert vorliegen.

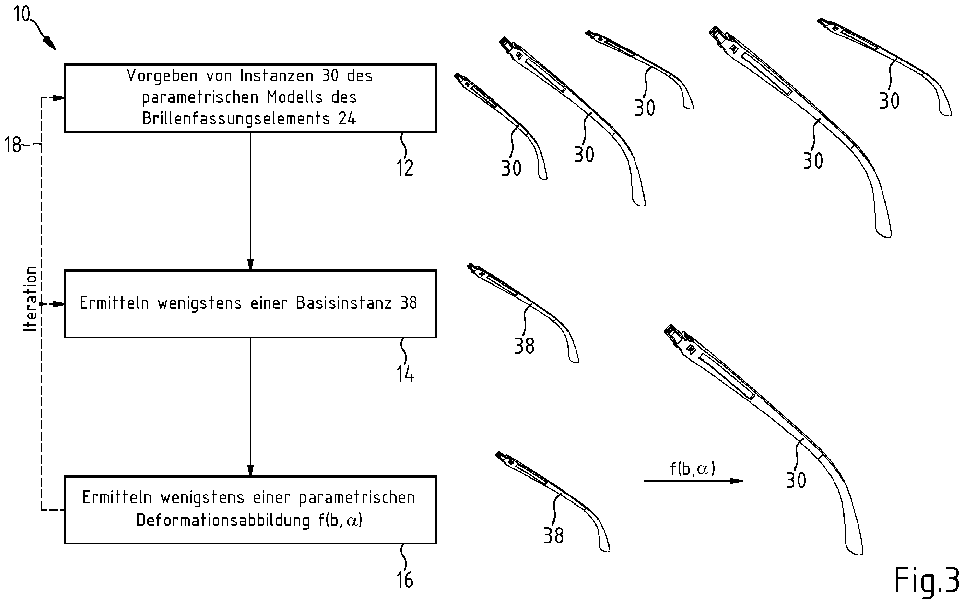

Die Fig. 3 zeigt Verfahrensschritte eines Verfahrens 10 zur Ermittlung eines wenigstens einen Parameter aufweisenden parametrischen Ersatzmodells eines Brillenfassungselements 24 für ein gegebenes parametrisches Modell des Brillenfassungselements 24.

Das in der Fig. 3 gezeigte Brillenfassungselement 24 ist ein Fassungsbügel. Dieses liegt als parametrisches Modell in Form eines CAD-Modells 22 vor. Das Verfahren 10 kann aber auch auf das parametrische Modell der gesamten Brillenfassung angewendet werden.

In einem ersten Verfahrensschritt 12 werden Instanzen 30 des parametrischen Modells des Brillenfassungselements 24 in Form des Fassungsbügels vorgegeben. Aus diesen vorgegebenen Instanzen wird in einem zweiten Schritt 14 wenigstens eine Basisinstanz 38 und in einem dritten Schritt 16 wenigstens eine parametrische Deformationsabbildung f(b, a) ermittelt. Die wenigstens eine parametrische Deformationsabbildung bildet eine Basisinstanz b anhand von Parametern in Form eines Parametervektors $\alpha$ auf eine Instanz 30 des parametrischen Ersatzmodells ab. Durch Einsetzen verschiedener Parameterwerte für $\alpha$ können verschiedene Instanzen 30 des parametrischen Ersatzmodells generiert werden, z. B. kann die Länge und/oder Breite der Fassungsbügel dadurch variiert werden, damit das Brillenfassungselement 24 an den Kopf des Brillenträgers angepasst werden kann.

Die Schritte des Verfahrens 10 zur Erzeugung des parametrischen Ersatzmodells des Brillenfassungselements 24 können in mehreren Iterationen 18 wiederholt werden.

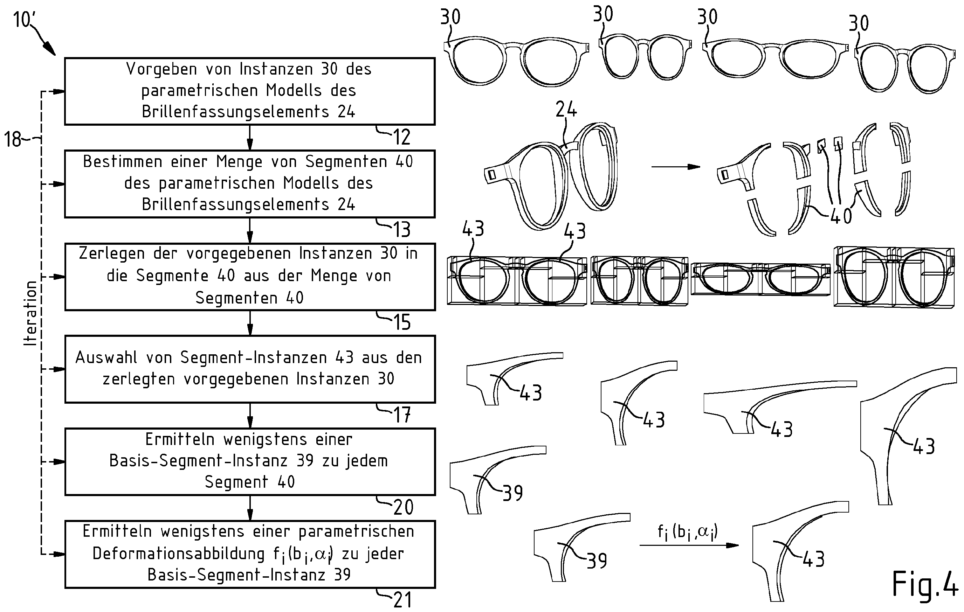

Die Fig. 4 zeigt Verfahrensschritte eines alternativen Verfahrens 10' zur Ermittlung eines wenigstens einen Parameter aufweisenden parametrischen Ersatzmodells eines Brillenfassungselements 24 für ein gegebenes parametrisches Modell des Brillenfassungselements 24.

Das in der Fig. 4 gezeigte Brillenfassungselement 24 ist ein Fassungsvorderteil. Dieses liegt als parametrisches Modell in Form eines CAD-Modells 22 vor.

In einem ersten Verfahrensschritt 12 werden mehrere Instanzen 30 des parametrischen Modells des Brillenfassungselements 24 in Form des Fassungsvorderteils vorgegeben. In einem zweiten Schritt 13 wird eine Menge von Segmenten 40 des parametrischen Modells des Brillenfassungselements 24 bestimmt. Die vorgegebenen Instanzen 30 des parametrischen Modells werden in einem weiteren Schritt 15 in die Segmente 40 aus der Menge von Segmenten 40 zerlegt. In einem nächsten Schritt 17 wird aus den zerlegten vorgegebenen Instanzen eine Menge von Segment-Instanzen 43 ausgewählt. Für jedes Segment 40 aus der Menge von Segmenten 40 wird also aus den zerlegten vorgegebenen Instanzen 30 das jeweilige Segment 40 ausgewählt und die ausgewählten Segmente 40 zu einer Menge vorgegebener Segment-Instanzen 43 kombiniert, wie z. B. in Fig. 4 für den oberen linken Teil des Fassungsvorderteils gezeigt. In einem weiteren Verfahrensschritt 20 wird zu jedem Segment 40 eine Basis-Segment-Instanz 39 ermittelt. Aus den vorgegebenen Segment-Instanzen wird also wie in dem oben beschriebenen Verfahren 10 eine Basisinstanz 38 bestimmt, die Basis-Segment-Instanz 39. Zusätzlich wird für jedes Segment i zu jeder Basis-Segment-Instanz $b_i$ eine parametrische Deformationsabbildung $f_i(b_i, \alpha_i)$ bestimmt, welche die Basis-Segment-Instanz $b_i$ anhand der Parameter $\alpha_i$ auf weitere Segment-Instanzen 43 des Segments i des parametrischen Ersatzmodells des Brillenfassungselements 24 abbildet. Die vorgegebenen Instanzen 30 können dabei durch Variation der Parameterwerte für die Parameter des CAD-Modells 22 erzeugt werden.

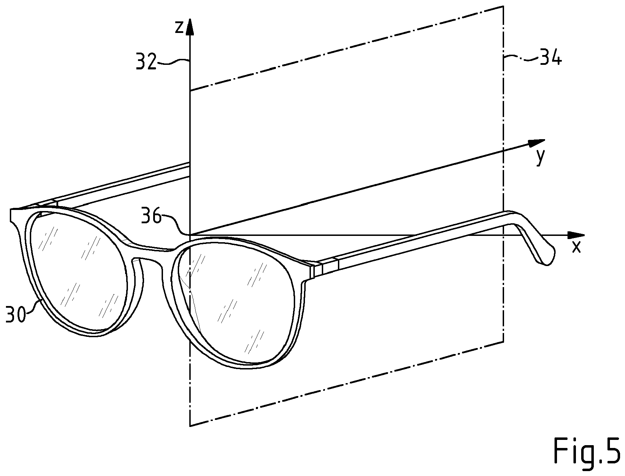

Dabei ist es von Vorteil, wenn, wie in der Fig. 5 gezeigt, die vorgegebenen Instanzen 30 in einem einzigen Koordinatensystem 32 vorliegen. Weiterhin ist es vorteilhaft, wenn die vorgegebenen Instanzen 30 derart in dem Koordinatensystem 32 positioniert und orientiert sind, dass der Schwerpunkt 36 der jeweiligen Instanz 30 mit dem Zentrum des Koordinatensystems 32 übereinstimmt und/oder eine Symmetrieebene 34 der jeweiligen Instanz 30 eine Achse des Koordinatensystems 32 enthält.

Die vorgegebenen Instanzen 30 können außerdem in einem Vorverarbeitungsschritt 44 vorverarbeitet werden, um Fehler, z. B. topologische Fehler wie Löcher oder eine unregelmäßige Triangulierung, z. B. eine unregelmäßige Dichte oder Größe der Oberflächendreiecke, zu korrigieren und/oder um den visuellen Eindruck der Instanzen 30 für den Brillenträgers zu verbessern. Dafür kann ein Poisson-Oberflächenrekonstruktions-Algorithmus verwendet werden, wie er z. B. in dem Artikel "Poisson Surface Reconstruction", Michael Kazhdan, Matthew Bolitho und Hugues Hoppe, Proceedings of the fourth Eurographics symposium on Geometry processing, 2006 beschrieben ist, auf den hiermit vollumfänglich Bezug genommen und dessen Offenbarungsgehalt in die Beschreibung dieser Erfindung mit einbezogen wird.

Die Schritte des Verfahrens 10' zur Erzeugung des parametrischen Ersatzmodells des Brillenfassungselements 24 können in mehreren Iterationen 18 wiederholt werden.

Bei der Bestimmung der Elemente des parametrischen Ersatzmodells ist es von Vorteil, ein Kriterium aus der Gruppe umfassend gewichtete Summe, Durchschnitt, Maximum und Quantile der Verteilung der Abweichungen zwischen Oberflächen der vorgegebenen Instanzen 30 des parametrischen Modells und Oberflächen aller anhand konkreter Parameterwerte erzeugbarer Instanzen 30 des parametrischen Ersatzmodells des wenigstens einen Brillenfassungselements 24 zu optimieren.

Von Vorteil ist es auch, wenn das parametrische Ersatzmodell in einem Datenformat bereitgestellt wird, das sich von dem des parametrischen Modells unterscheidet. Denn dadurch kann das parametrische Ersatzmodell unabhängig von dem Programm und dem Datenformat verwendet werden, in dem das parametrische Modell vorliegt.

In dem zweiten Schritt 13 des Verfahrens 10' wird eine Menge von Segmenten 40 des parametrischen Modells des Brillenfassungselements 24 bestimmt. Diese Maßnahme zielt darauf ab, bestmöglich die virtuelle Herstellungsweise des parametrischen Modells des Fassungsherstellers abzubilden.

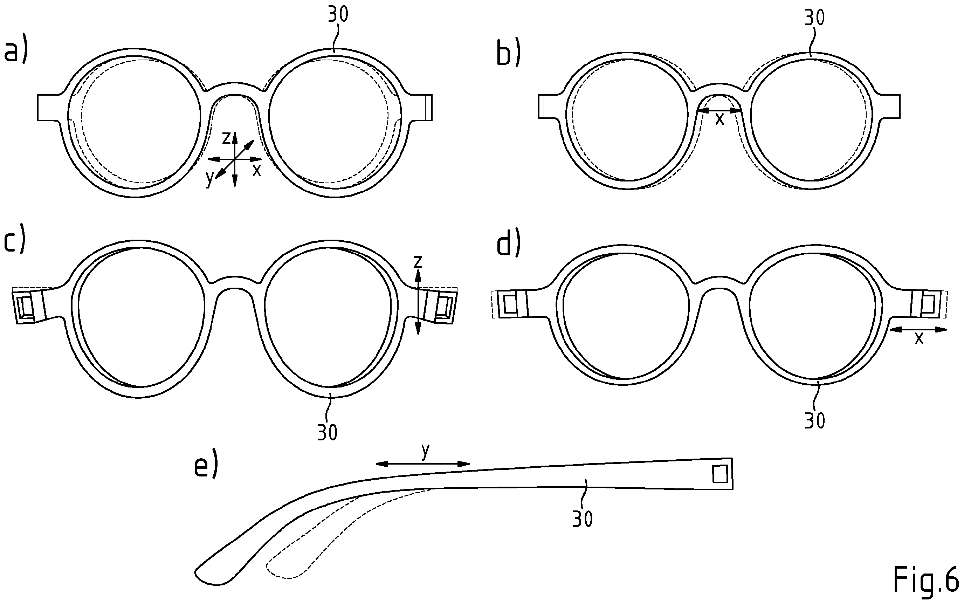

Zur Ermittlung der Menge von Segmenten 40 können, wie in der Fig. 6 gezeigt, anhand der vorgegebenen Instanzen 30 des parametrischen Modells des Brillenfassungselements 24 die Auswirkungen der verschiedenen Parameter des vom Fassungshersteller erstellten CAD-Modells 22, wie z. B. Fassungsgröße, Bügellänge, Brückenweite, Inklinationswinkel und Öffnungswinkel auf die Geometrie des parametrischen Modells des Brillenfassungselements 24 untersucht werden. Die Instanzen 30 können dann z. B. anhand der Bewegung der Oberflächenpunkte 28 des Meshs 26 über verschiedene Instanzen 30 hinweg analysiert werden. Beispielsweise können alle Oberflächenpunkte 28, die der gleichen Bewegung folgen, oder alle Oberflächenpunkte 28, die sich nicht bewegen, zu einem Segment 30 zusammengefasst werden.

Wie in der Fig. 6A gezeigt, skaliert die Größe der Fassung das Mesh 26 in allen Raumrichtungen. Die Brückenweite in der Fig. 6B skaliert die Fassung entlang der Horizontalen. Der Inklinationswinkel in der Fig. 6C bewegt die Regionen des Fassungsvorderteils, an denen die Fassungsbügel montiert sind, in vertikaler Richtung, während der Öffnungswinkel in der Fig. 6D diese Regionen in horizontaler Richtung bewegt. Die Bügellänge in der Fig. 6E skaliert die Länge der Bügel. Für das Fassungsvorderteil kann die derart ermittelte Menge von Segmenten 40 z. B. zwölf Elemente enthalten.

Zu den Segmenten 40 aus der Menge der Segmente 40 des parametrischen Ersatzmodells des wenigstens einen Brillenfassungselements 24 können zusätzliche Merkmale für die Anpassung dieses an den Kopf des Brillenträgers bestimmt werden, z. B. Ohrauflagepunkte für die Fassungsbügel, Auflagekurven der Enden der Fassungsbügel, 3D-Glasebenen als Approximation für die in die Brillenfassung einzupassenden Gläser, 3D-Boxen zur Approximation der Fassungsränder des Fassungsvorderteils, Nasenpads und/oder Nasenauflagepunkte für das Fassungsvorderteil. Diese zusätzlichen Daten können eine manuelle Interaktion des Anwenders erfordern, z. B. durch Auswählen von Punkten oder Geraden in den an einem Bildschirm zur Anzeige gebrachten Daten.

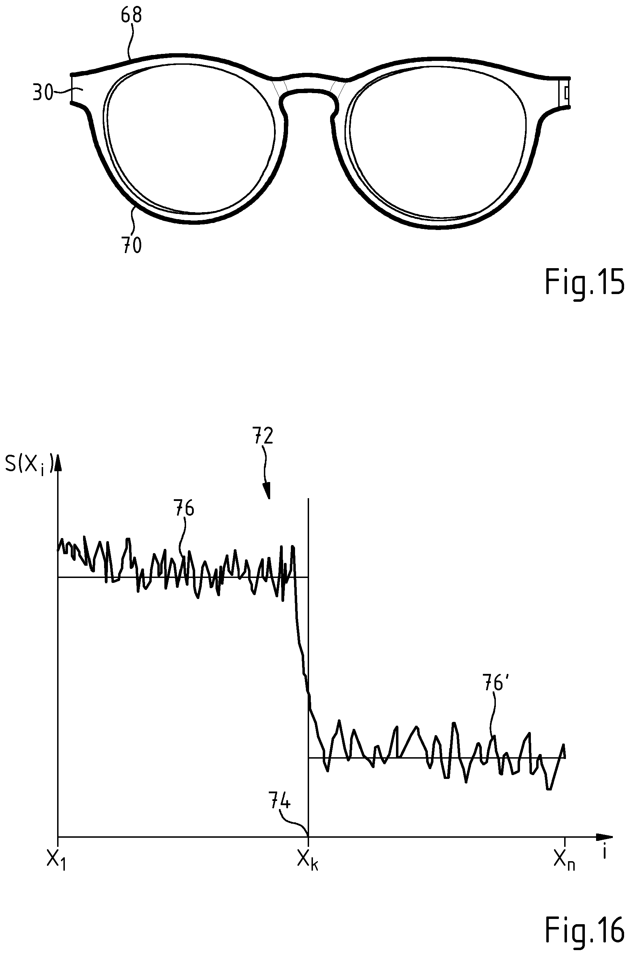

In dem Schritt 15 des Verfahrens 10' werden die vorgegebenen Instanzen 30 des Fassungsvorderteils in Segmente 40 aus der Menge von Segmenten 40 zerlegt. Die Segmentierung der Instanzen 30 kann manuell durch Eingabe eines Anwenders über die Anwenderschnittstelle oder automatisch mittels eines Algorithmus, wie anhand der Fig. 16 bis 19 beschrieben, erfolgen.

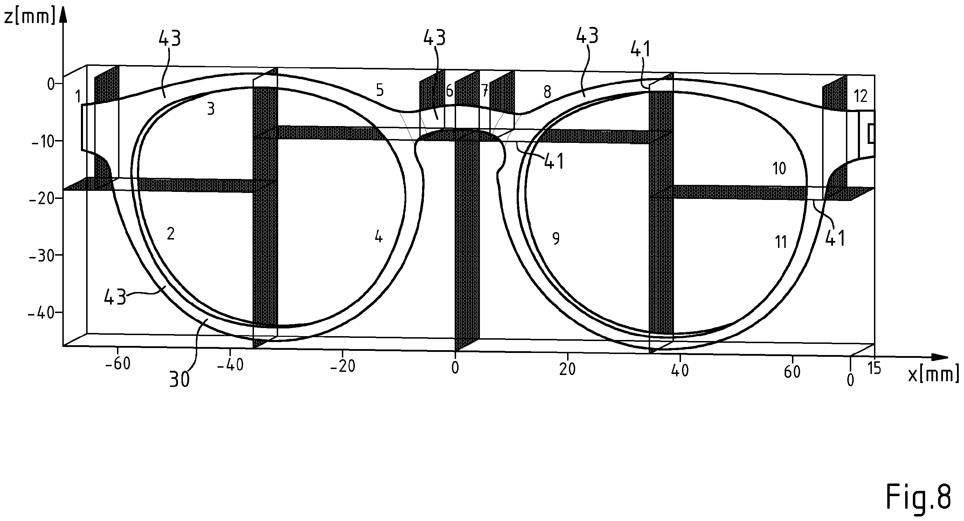

Das Fassungsvorderteil wird beispielsweise in die in der Fig. 8 gezeigten zwölf Segmente zerlegt, die durch die Zahlen 1 bis 12 gekennzeichnet sind. Die eingezeichneten Ebenen zeigen jeweils die Segmentgrenzen 41 an. Diese Ebenen können z. B. anhand eines Algorithmus zur Detektion von Wendepunkten 74, wie weiter unten beschrieben, bestimmt werden.

Liegen die vorgegebenen Instanzen 30 als Mesh 26 vor, so ist es vorteilhaft, wenn sie derart in disjunkte Segmente 40 aus der Menge der Segmente 40 partitioniert werden, dass jede Segment-Instanz 43 aus einer in Bezug auf die Triangulierung des Meshs 26 zusammenhängenden Menge von Oberflächenpunkten 28 besteht. Die Triangulierung des Meshs 26 wird in diesem Fall auch nach der Zerlegung der vorgegebenen Instanzen 30 in Segmente 40 beibehalten.

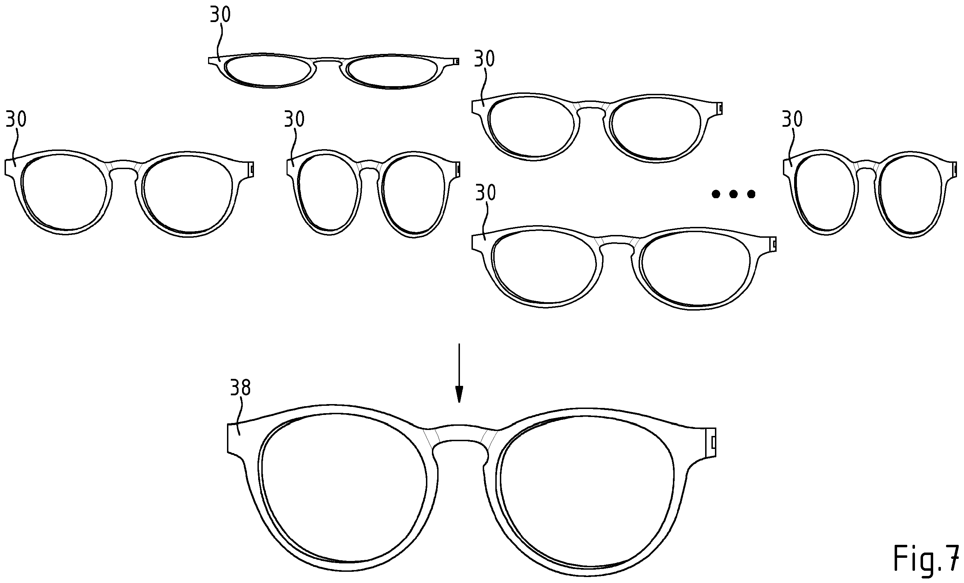

In dem zweiten Schritt 14 des Verfahrens 10 wird wenigstens eine Basisinstanz 38 anhand der vorgegebenen Instanzen 30 des parametrischen Modells des Brillenfassungselements 24, wie in Fig. 7 gezeigt, bereitgestellt. Insbesondere eignet sich hier eine Instanz 30, die auf Basis des Mittelwerts oder Medians des Wertebereichs oder des Erwartungswerts der Wahrscheinlichkeitsverteilung des jeweiligen Parameters erzeugt wurde.

Alternativ kann auch eine der vorgegebenen Instanzen 30 als Basisinstanz 38 ausgewählt werden. Die wenigstens eine Basisinstanz 38 kann dabei derart gewählt werden, dass weitere Instanzen 30, z. B. die übrigen vorgegebenen Instanzen 30, durch Anwendung der parametrischen Deformationsabbildungen mit möglichst geringem Fehler reproduzierbar sind.

Die Auswahl der wenigstens einen Basisinstanz 38 kann auch anhand von Eingaben eines Anwenders über die Anwenderschnittstelle oder automatisch durch einen Algorithmus vorgenommen werden. Der Algorithmus kann dabei Gütekriterien, z. B. die Abweichung der anhand des parametrischen Ersatzmodells reproduzierten Instanzen 30 von den vorgegebenen Instanzen 30, bewerten.

Die wenigstens eine Basis-Segment-Instanz 39 kann auf die gleiche Weise aus den in Segmente 40 zerlegten vorgegebenen Instanzen 30, den Segment-Instanzen 39, bestimmt werden.

In dem letzten Schritt 16 des Verfahrens 10 wird wenigstens eine parametrische Deformationsabbildung für die wenigstens einen Basisinstanz 38 zur Abbildung dieser auf weitere Instanzen 30 des parametrischen Modells des Brillenfassungselements 24 bestimmt. Die wenigstens eine parametrische Deformationsabbildung wird dabei in Form einer Abbildung $f(b, a)$ mit zu bestimmenden Parametern $\alpha$ festgelegt, welche die Basisinstanz $b$ verändern.

Als Deformationsabbildungen können beispielsweise affine Abbildungen, die eine Rotation, eine Translation und eine Skalierung der Segmente 40 beschreiben, gewählt werden.

Von Vorteil ist es, wenn die wenigstens eine parametrische Deformationsabbildung des parametrischen Ersatzmodells aus der Gruppe umfassend affine Abbildungen, Polynome, polynomiale Flächen, Bezier-Kurven, Splines oder NURBS stammen.

Insbesondere ist es von Vorteil, wenn die Segmente 40 aus der Menge von Segmenten 40 des parametrischen Ersatzmodells als statisch, beweglich oder deformierbar gekennzeichnet werden.

Es ist besonders von Vorteil, wenn die parametrischen Deformationsabbildungen der als statisch gekennzeichneten Segmente 40 lineare Abbildungen sind, die parametrischen Deformationsabbildungen der als beweglich gekennzeichneten Segmente 40 affine Abbildungen sind und die parametrischen Deformationsabbildungen der als deformierbar gekennzeichneten Segmente 40 anhand von Polynomen, polynomialen Flächen, Bezier-Kurven, Splines oder NURBS approximiert werden.

Bei als beweglich oder deformierbar gekennzeichnete Segmenten 40, die keiner einheitlichen Bewegung folgen, kann es sich um Anschlussflächen zwischen Brillenfassungselementen 24 und/oder Segmenten 40 handeln. Diese umfassen Kontaktkurven im jeweiligen Kontaktbereich zum benachbarten Segment 40. Für diese kann es von Vorteil sein, wenn zusätzliche Anschlussbedingungen in Form von Punkten und Normalenvektoren an wenigen Stellen der Kontaktkurve definiert werden.

Für jedes Segment 40 aus der Menge von Segmenten 40 wird wenigstens eine Basis-Segment-Instanz 39 und wenigstens eine parametrische Deformationsabbildung derart ermittelt, dass die wenigstens eine parametrische Deformationsabbildung die Basis-Segment-Instanz 43 auf weitere Segment-Instanzen 39 mit möglichst geringer Abweichung abbildet.

Es ist von Vorteil, wenn zur Bestimmung der Elemente des parametrischen Ersatzmodells des Brillenfassungselements 24, insbesondere der Menge der Segmente 40, der wenigstens einen Basisinstanz 38 und/oder der parametrischen Deformationsabbildungen ein Algorithmus verwendet wird, der die Abweichung von Instanzen 30 des parametrischen Modells von allen erzeugbaren Instanzen 30 des parametrischen Ersatzmodells minimiert.

Zur Ermittlung der Elemente des parametrischen Ersatzmodells, insbesondere der wenigstens einen Basisinstanz 38 und der wenigstens einen parametrischen Deformationsabbildung, können maschinelle Lernverfahren verwendet werden. Dies gilt ebenso für die Ermittlung der wenigstens einen Basis-Segment-Instanz 39 und der wenigstens einen parametrischen Deformationsabbildung für das Verfahren 10'.

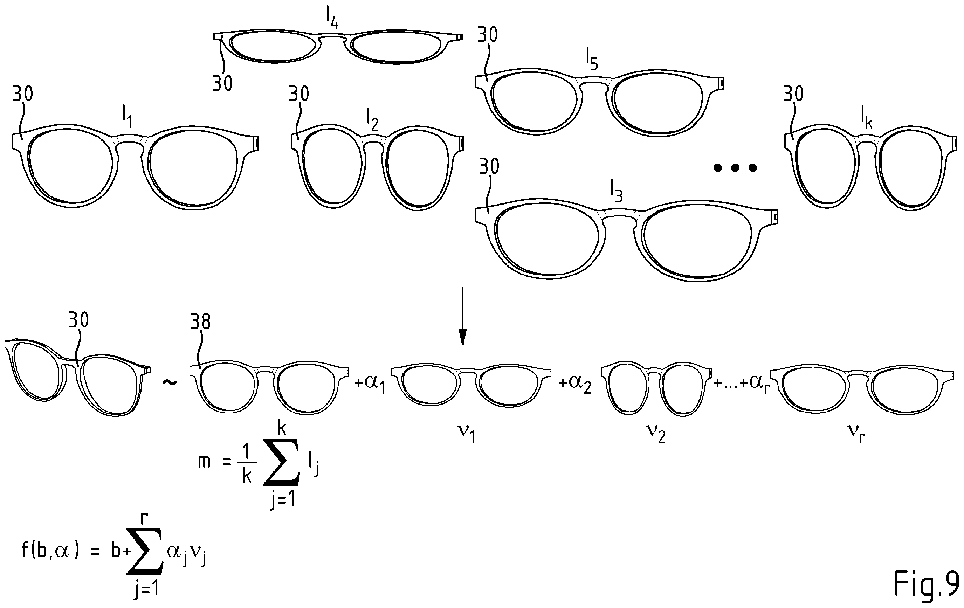

Vorzugsweise kann hier, wie in Fig. 9 dargestellt, eine Hauptkomponentenanalyse zum Einsatz kommen. Der Mittelwert der vorgegebenen Instanzen 30 bildet dann die Basisinstanz b. Anhand der Eigenvektoren $v_i$ der Kovarianzmatrix der Instanzen 30 nach Abzug des Mittelwerts wird die parametrische Deformationsabbildung bestimmt. Um eine geringere Komplexität des parametrischen Ersatzmodells zu erreichen, können dafür nur die n Eigenvektoren zu den n größten Eigenwerten ausgewählt werden:

$$f(b, \alpha) = b + \sum_{i=1}^{n} \alpha_i v_i$$

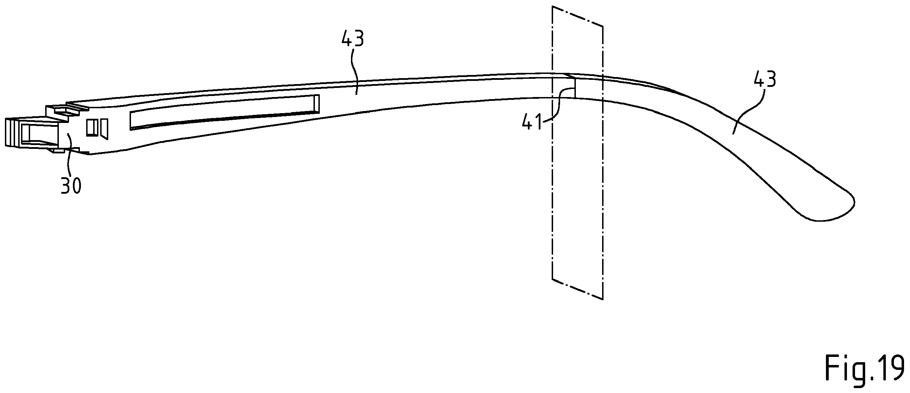

Liegt eine spezielle Instanz 30 eines CAD-Modells 22 eines Brillenfassungselements 24 vor, so kann diese anhand des parametrischen Ersatzmodells des wenigstens einen Brillenfassungselements 24 zu diesem CAD-Modell 22 des Brillenfassungselements 24 wie folgt dargestellt werden. Zuerst wird die Instanz 30 in die Segmente 40 aus der Menge von Segmenten 40 des parametrischen Ersatzmodells des wenigstens einen Brillenfassungselements 24 zerlegt. Dann wird eine Basisinstanz 38 des parametrischen Ersatzmodells des Brillenfassungselements 24 ausgewählt. Zu jedem der Segmente 40 kann dann die konkrete Deformationsabbildung berechnet werden, die das jeweilige Segment 40 der Basisinstanz 38 auf das entsprechende Segment 40 der speziellen Instanz 30 abbildet, wie z. B. weiter unten anhand der Fig. 16 und 19 beschrieben. Die Instanz 30 kann somit anhand des parametrischen Ersatzmodells des Brillenfassungselements 24 lediglich durch Angabe der ausgewählten Basisinstanz 38 und der Parameterwerte für die parametrischen Deformationsabbildungen für jedes der Segmente 40 der ausgewählten Basisinstanz 38 näherungsweise dargestellt werden.

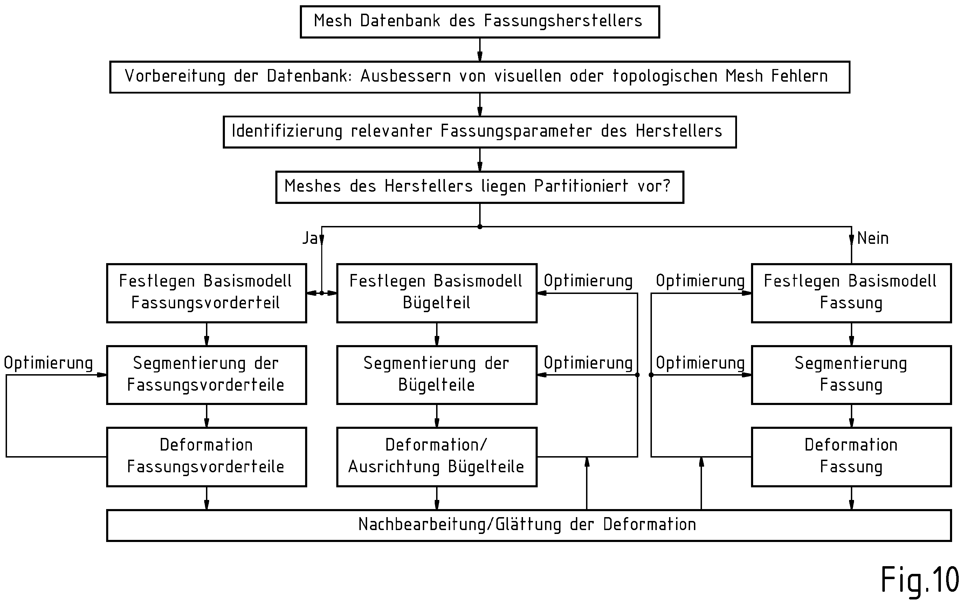

Die Fig. 10 zeigt, wie ein parametrisches Ersatzmodell eines Brillenfassungselements 24 zu vorgegebenen Instanzen 30, denen ein gemeinsames parametrisches Modell zu Grunde liegt, bestimmt wird. Die vorgegebenen Instanzen 30 können dabei in Form von Meshes 26 in einer Datenbank 42 des Fassungsherstellers abgespeichert sein.

Die vorgegebenen Instanzen können zur Ausbesserung visueller oder topologischer Fehler in einem Vorverarbeitungsschritt 44 vorverarbeitet werden.

In einem nächsten Schritt wird, wie anhand der Fig. 6 beschrieben, für jedes Brillenfassungselement 24 durch Identifizieren relevanter Fassungsparameter des Herstellers eine passende Menge von Segmenten 40 ermittelt.

In einem Schritt 14 wird dann wenigstens eine Basisinstanz 38 des parametrischen Ersatzmodells des Brillenfassungselements 24 durch Auswahl einer Instanz 30 aus der Kollektion von Instanzen 30, den vorgegebenen Instanzen, bestimmt. In dem folgenden Schritt 16 wird die Basisinstanz 38 in die Menge von Segmenten 40 zerlegt. Danach werden auch die vorgegebenen Instanzen 30 in die Segmente 40 aus der Menge von Segmenten 40 zerlegt. Danach werden die parametrischen Deformationsabbildungen so ausgewählt, dass der Rekonstruktionsfehler auf den vorgegebenen Instanzen 30 möglichst gering ist. Die Schritte zur Ermittlung der Basisinstanz, der Segmentierung der Basisinstanz und der Ermittlung der parametrischen Deformationsabbildungen werden iteriert, bis die geforderten Gütekriterien in Form von maximalen Abweichungen der Oberflächenpunkte 28 der Instanzen 30 der Kollektion von Instanzen 30 von den Oberflächenpunkten 28 der jeweiligen anhand des parametrischen Ersatzmodells dargestellten Instanzen 30 erfüllt sind.

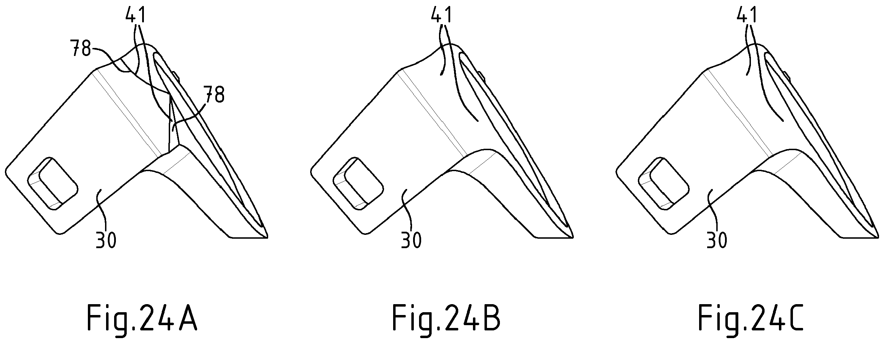

Da für jedes Segment 40 der wenigstens einen Basisinstanz 38 des Brillenfassungselements 24 eine eigene Deformationsabbildung unabhängig von den anderen Segmenten 40 bestimmt wird, kann es zu Sprungstellen 78 an den Segmentgrenzen 41 kommen. Diese können durch ein Glättungsverfahren verhindert werden, das in einem Nachverarbeitungsschritt 46 auf die erzeugten Meshes 26 der Instanzen 30, wie anhand der Fig. 24 beschrieben, angewendet wird. Ein zusätzlicher Verfahrensschritt zum Bestimmen eines Nachverarbeitungsverfahrens, insbesondere eines Glättungsverfahrens, für die anhand des parametrischen Ersatzmodells erzeugten Instanzen 30 ist deshalb von Vorteil.

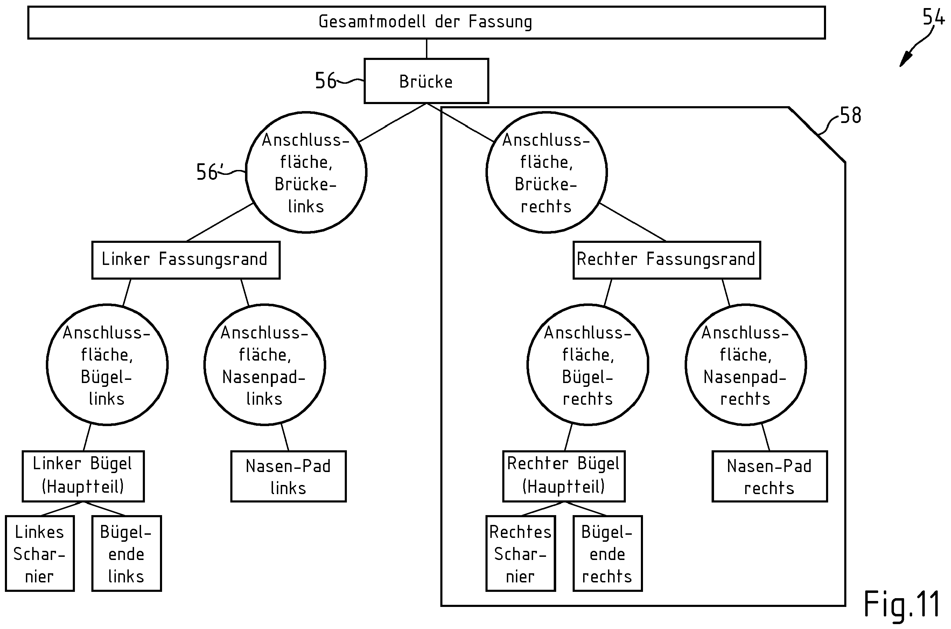

Die Fig. 11 zeigt eine Anordnung der Segmente 40 aus der Menge von Segmenten 40 eines parametrischen Ersatzmodells eines Brillenfassungselements 24, in diesem Fall der gesamten Brillenfassung. Die Segmente 40 sind ihrem räumlichen Zusammenhang nach in einer hierarchischen Baumstruktur 54 angeordnet. Miteinander verbundene Knoten 56, 56' zeigen dabei eine räumliche Nachbarschaft der Segmente 40 an, d. h. diese Segmente 40 besitzen eine gemeinsame Schnittkante oder -fläche. Jedes Segment 40 in der Baumstruktur 54 ist dabei relativ zu seinem Vorgängerknoten in einem Koordinatensystem 32 positioniert und orientiert.

Der rechte Unterbaum 58 des Knotens "Brücke" beschreibt den rechten Teil des parametrischen Modells der Brillenfassung bis zur Brücke, der linke Unterbaum 58 den linken Teil bis zur Brücke. Beide Unterbäume 58 des Brücken-Knotens sind symmetrisch, da auch die beiden Hälften des parametrischen Modells der Brillenfassung symmetrisch sind.

Bei Vorliegen mehrerer Brillenfassungselemente 24 können auch diese hierarchisch in einer Baumstruktur 54, wie z. B. in der Fig. 11 gezeigt, angeordnet sein.

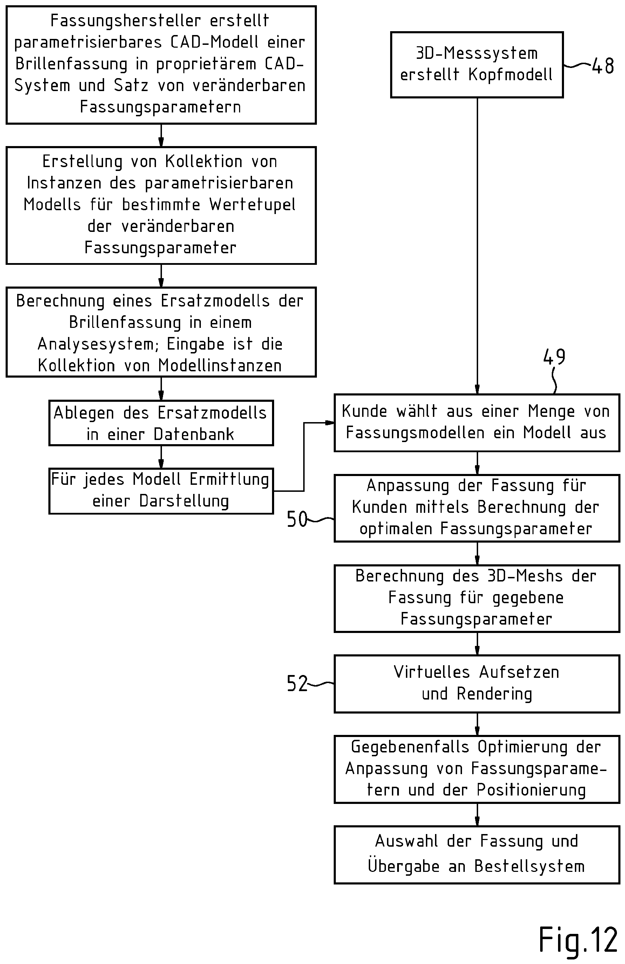

In der Fig. 12 ist ein computerimplementiertes Verfahren zur Individualisierung eines Brillenfassungselements 24 durch Anpassung eines parametrischen Modells eines Brillenfassungselements 24 an den Kopf eines Brillenträgers anhand eines in einem zuvor beschriebenen Verfahren zur Ermittlung eines wenigstens einen Parameter aufweisenden parametrischen Ersatzmodells des Brillenfassungselements 24 dargestellt. Dabei wird eine Darstellung des Kopfes in einem Koordinatensystem 32 in einer Rechnereinheit ermittelt. Weiter wird ein Parameterwert für den wenigstens einen Parameter des parametrischen Ersatzmodells des Brillenfassungselements 24 ermittelt, sodass die anhand dieses wenigstens einen Parameterwerts erzeugte Instanz 30 des parametrischen Ersatzmodells des Brillenfassungselements 24 an den Kopf angepasst ist.

Der Fassungshersteller erstellt dazu ein CAD-Modell 22 des Brillenfassungselements 24 mit veränderbaren Parametern. Um für dieses Modell ein parametrisches Ersatzmodell des Brillenfassungselements 24 zu bestimmen, wird eine Menge vorgegebener Instanzen 30 des CAD-Modells für verschiedene Parametersätze erstellt. Aus den vorgegebenen Instanzen 30 wird das parametrische Ersatzmodell des Brillenfassungselements 24 anhand eines zuvor beschriebenen Verfahrens berechnet. Dieses parametrische Ersatzmodell des Brillenfassungselements 24 kann in einer Datenbank 42 abgelegt werden. In der Datenbank 42 kann dann für verschiedene CAD-Modelle 22 unterschiedlicher Brillenfassungselemente 24 jeweils ein parametrisches Ersatzmodell abspeichert werden.

Diese Datenbank 42 mit parametrischen Ersatzmodellen von Brillenfassungselementen 24 kann dann z. B. wie folgt in einem System zur Individualisierung und Anpassung von Brillenfassungselementen 24 verwendet werden: In einem ersten Schritt 48 wird eine Darstellung des Kopfes des Brillenträgers anhand eines Kopfmodells in einem Koordinatensystem mittels eines 3D-Messsystems erstellt. Zu jedem parametrischen Ersatzmodell in der Datenbank 42 wird eine Darstellung für einen konkreten Parametersatz erzeugt. Diese Darstellung kann auch in der Datenbank 42 mit abgespeichert werden, um Rechenzeit einzusparen.

Der Brillenträger kann aus den Darstellungen der parametrischen Ersatzmodelle der verschiedenen Brillenfassungselemente 24 ein Brillenfassungselement 24 in einem weiteren Schritt 49 auswählen. Dieses Brillenfassungselement 24 kann anhand des parametrischen Ersatzmodells in einem Schritt 50 an das zuvor erstellte Kopfmodell mittels Algorithmen angepasst werden, wie sie z. B. in der EP 3 425 447 A1 oder der EP 3 425 446 A1 beschrieben sind, auf die hiermit vollumfänglich Bezug genommen und deren Offenbarung in die Beschreibung dieser Erfindung einbezogen wird.

Dafür wird eine Basisinstanz 38 zusammen mit einer Zerlegung dieser in Segmente 40 des parametrischen Ersatzmodells des Brillenfassungselements 24 ausgewählt. Diese wird in das Koordinatensystem 32 des Kopfmodells transformiert. Schließlich werden die Parameter der parametrischen Deformationsabbildungen zu jedem der Segmente 40 der Basisinstanz 38 derart optimiert, dass das Brillenfassungselement 24 an das Kopfmodell angepasst ist.

Zu bemerken ist, dass das Brillenfassungselement 24 anhand des parametrischen Ersatzmodells in dem Schritt 50 an das zuvor erstellte Kopfmodell grundsätzlich auch manuell anhand von Anwendereingaben über eine Nutzerschnittstelle optimal angepasst werden kann. Die hierbei bestimmten Parameterwerte werden für den Brillenträger gespeichert.

Zu dem ausgewählten parametrischen Ersatzmodell des Brillenfassungselements 24 und den optimierten Parameterwerten dieses Modells wird dann ein Mesh 26 des Brillenfassungselements 24 berechnet. Dieses kann in einem Schritt 52 in Trageposition auf dem Kopfmodell des Brillenträgers angezeigt werden.

Gegebenenfalls können Parameterwerte des parametrischen Ersatzmodells des Brillenfassungselements 24 oder die Position des gerenderten Brillenfassungselements 24 auf dem Kopfmodell angepasst werden.

Das ausgewählte Brillenfassungselement 24 kann dann an ein Bestellsystem übertragen werden.

Sind die verschiedenen Brillenfassungselemente 24 zusammen mit ihren parametrischen Ersatzmodellen im Bestellsystem hinterlegt, so müssen für eine Bestellung lediglich die berechneten Parameterwerte des parametrischen Ersatzmodells, d. h. gegebenenfalls der Index der ausgewählten Basisinstanz 38, falls mehrere in dem Modell enthalten sind, und die Parameterwerte der Deformationsabbildungen, übertragen werden, was Übertragungszeit spart und auch bei einer Internetanbindung mit geringer Bandbreite möglich ist.

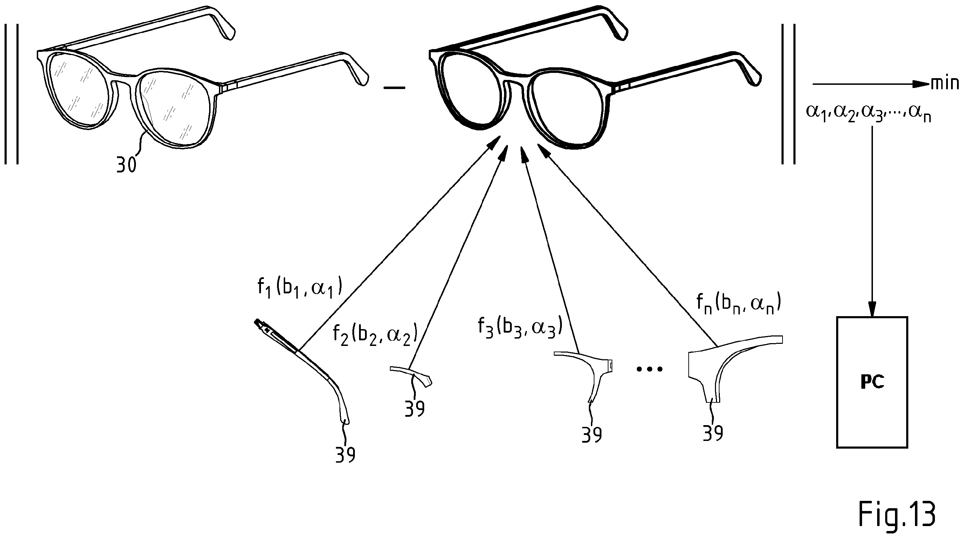

Anhand von Fig. 13 ist ein computerimplementiertes Verfahren zur Darstellung und/oder Kompression einer gegebenen Instanz 30 eines parametrischen Modells eines Brillenfassungselements 24 anhand eines in einem oben beschriebenen Verfahren ermittelten wenigstens einen Parameter aufweisenden parametrischen Ersatzmodells des Brillenfassungselements 24 in einer Rechnereinheit beschrieben. Dabei wird in einem ersten Schritt für jeden Parameter des parametrischen Ersatzmodells ein Parameterwert ermittelt, indem ein Kriterium aus der Gruppe umfassend gewichtete Summe, Durchschnitt, Maximum und Quantile der Verteilung der Abweichungen zwischen Oberflächen der gegebenen Instanz 30 des parametrischen Modells und Oberflächen der anhand dieses wenigstens einen Parameterwerts erzeugten Instanz 30 des parametrischen Ersatzmodells optimiert wird. Der ermittelte wenigstens eine Parameterwert wird in einem Speicher der Rechnereinheit abgespeichert. Fig. 13 zeigt, dass für diese Maßnahme die Abweichung der gegebenen Instanz 30 von den anhand des parametrischen Ersatzmodells erzeugbaren Instanzen 30 durch das Ermitteln optimaler Parameterwerte minimiert wird. Diese Parameterwerte werden in einem Speicher einer Rechnereinheit abgespeichert. Die anhand des parametrischen Ersatzmodells erzeugbaren Instanzen 30 werden dabei durch die Zerlegung des parametrischen Modells in die Menge von Segmenten 40 und die Anwendung der parametrischen Deformationsabbildungen $f_1(b_1, \alpha_1)$, ..., $f_n(b_n, \alpha_n)$ auf die verschiedenen Basis-Segment-Instanzen 39 zu den n Segmenten erzeugt.

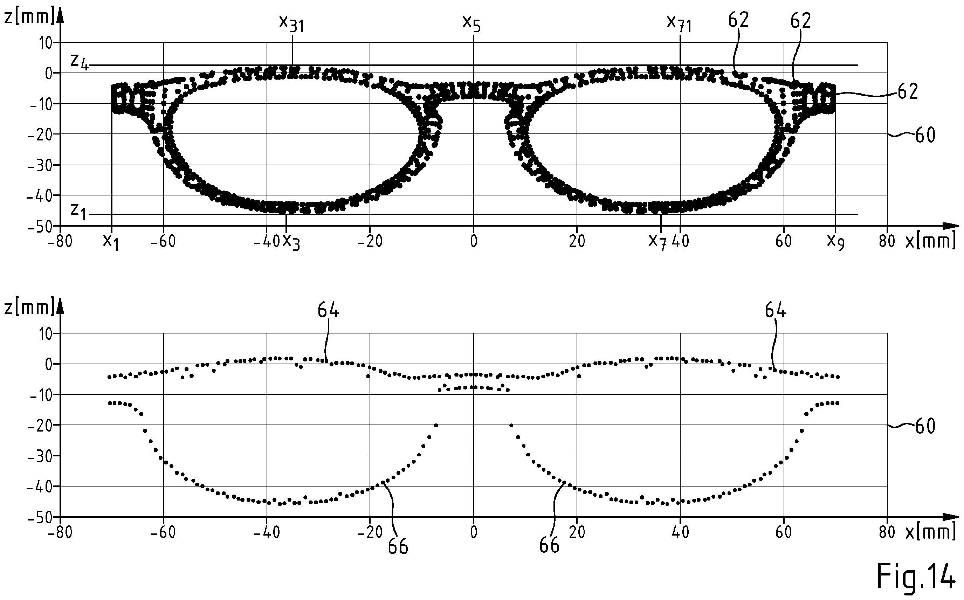

In der Fig. 14 bis 20 ist beschrieben, wie die Zerlegung einer Instanz 30 eines parametrischen Modells oder eines parametrischen Ersatzmodells eines Brillenfassungselements 24 in die Segmente 40 aus der Menge von Segmenten 40 automatisch anhand eines Algorithmus bestimmt werden kann.

Der Algorithmus umfasst die folgenden Schritte: Projektion der Oberflächenpunkte 28 des Meshs 26 der Instanz 30 auf eine Ebene 60, Ermittlung von Signalen 72 in den Projektionspunkten 62, die zu Fassungsrändern 68, 70 der Instanz 30 gehören, sowie Bestimmung der Wendepunkte 74 dieser Signale 72 und der Mittelwerte der Teilsignale 76, 76'. Die Zerlegung kann dann mit einem Parametersatz aus n Elementen $Z \subset \mathbb{R}^n$ beschrieben werden.

In dem vorliegenden Beispiel des Fassungsvorderteils besteht die Menge von Segmenten 40 aus zwölf Segmenten 40. Damit das Segmentierungsverfahren auf verschiedene Instanzen 30 desselben parametrischen Modells anwendbar ist, liegen die Instanzen 30 in einem Koordinatensystem 32 ausgerichtet, wie anhand der Fig. 5 beschrieben, vor.

Die Oberflächenpunkte 28 des Meshs 26 der zu zerlegenden Instanz 30 werden entlang einer Raumachse auf eine Ebene 60 projiziert, wie in der Fig. 14 gezeigt. Die Projektionspunkte 62 in Form der projizierten Punkte können entlang einer Achse, hier der Abszisse, sortiert werden.

Aus den Projektionspunkten 62 werden zwei Mengen ausgewählt: die erste Menge 64 enthält Projektionspunkte 62 zu Oberflächenpunkte 28 des in der Fig. 15 gezeigten oberen Fassungsrandes 68 der Instanz 30 des CAD-Modells des Fassungsvorderteils. Die zweite Menge 66 enthält Projektionspunkte 62 zu Oberflächenpunkten 28 des unteren Fassungsrandes 70 der Instanz 30 des CAD-Modells des Fassungsvorderteils in Fig. 15.

Beispielsweise kann dazu die Abszisse in regelmäßigen Schrittweiten, z. B. von 1mm, abgetastet werden.

Um die erste Menge 64 von Projektionspunkten 62 zu erhalten, kann zu jedem Abtastwert auf der Abszisse eine Menge von Projektionspunkten 62 mit einem ähnlichen Abszissenwert bestimmt und daraus der Projektionspunkt 62 mit dem größten Wert auf der Ordinatenachse ausgewählt werden.

Um die zweite Menge 66 von Projektionspunkten 62 zu erhalten, kann zu jedem Abtastwert auf der Abszisse eine Menge von Projektionspunkten 62 mit einem ähnlichen Abszissenwert bestimmt und daraus der Projektionspunkt 62 mit dem kleinsten Wert auf der Ordinatenachse ausgewählt werden.

Anhand der ersten Menge 64 und der zweiten Menge 66 von Projektionspunkten 62 zu einer Instanz 30 des parametrischen Modells eines Brillenfassungselements 24 kann dann die Instanz 30 automatisch mittels eines Algorithmus in Segmente 40 aus der Menge der Segmente 40 zerlegt werden.

Die durch die erste Menge 64 von Projektionspunkten 62 repräsentierte obere Kontur 64 in der Ebene 60 und die durch die zweite Menge 66 von Projektionspunkten 62 repräsentierte untere Kontur 66 in der Ebene 60 lassen sich als Signale 72 auffassen, zu deren Zerlegung Algorithmen aus der Signalverarbeitung verwendet werden können, z. B. ein Algorithmus zur Detektion von Wendepunkten 74 wie in dem Artikel "Using penalized contrasts for the change-point problem, Marc Lavielle, Signal Processing, 2005, Band 85, S. 1801 - 1810" beschrieben, auf den hiermit vollumfänglich Bezug genommen und dessen Offenbarungsgehalt in die Beschreibung dieser Erfindung mit einbezogen wird.

Liegt ein Signal 72 wie das in der Fig. 16 gezeigte vor, so können die Wendepunkte 74 dieses Signals 72 anhand dieses Algorithmus automatisch bestimmt werden. Sei $S: \mathbb{R} \to \mathbb{R}$ das kontinuierliche Signal 72, das an den Abstastpunkten $X_1,...X_n$ (horizontale Achse) die Werte $S(X_1),...S(X_n)$ (vertikale Achse) annimmt. Dann kann ein Wendepunkt 74 in dem $X_1,...X_n$ enthaltenden Abschnitt des Signals 72 berechnet werden, indem die Zielfunktion

$J: \mathbb{N} \to \mathbb{R}_0^+$ umfassend die Summe der Varianzen des ersten Teilsignals 76 enthaltend $X_1,...X_{k-1}$ und des zweiten Teilsignals 76' enthaltend $X_k...X_n$ anhand des folgenden Optimierungsproblems minimiert wird:

$$\min_k J(k) = (k-1) \cdot Var(S(X_1),...,S(X_{k-1})) + (N-k+1) \cdot$$

$$Var(S(X_k),...,S(X_N)) \tag{1}$$

Das Optimierungsproblem (1) kann derart abgewandelt werden, dass beliebig viele Wendepunkte 74 in einem Signal 72 detektiert werden können.

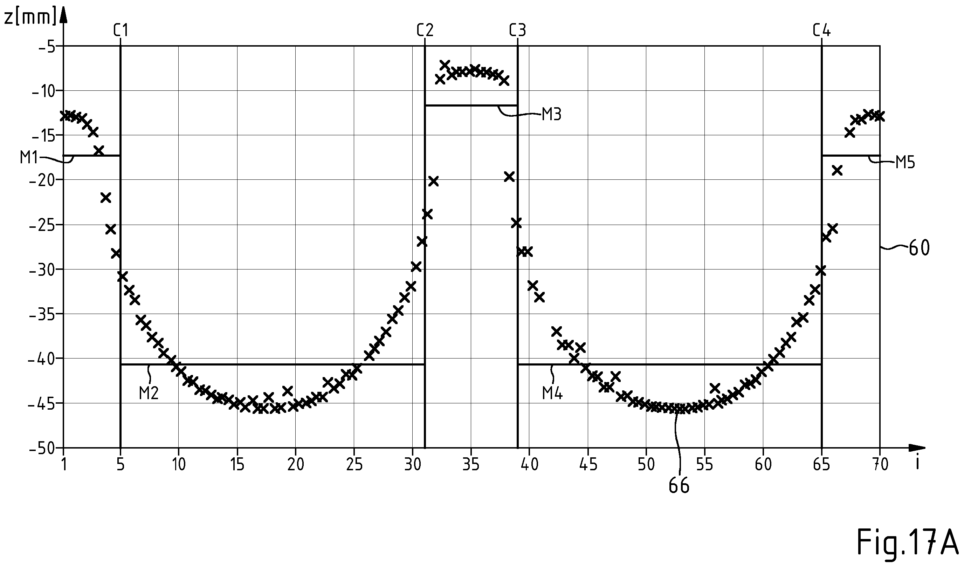

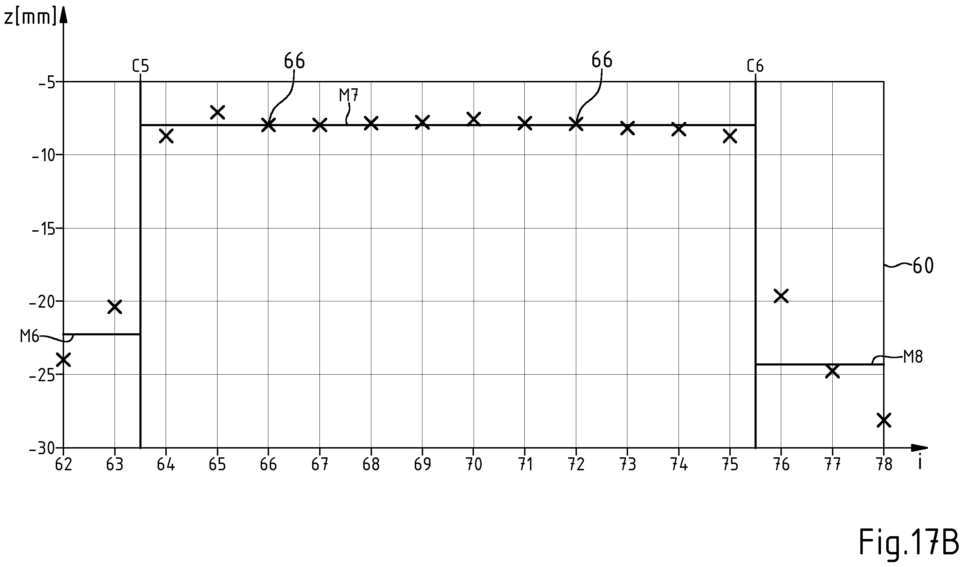

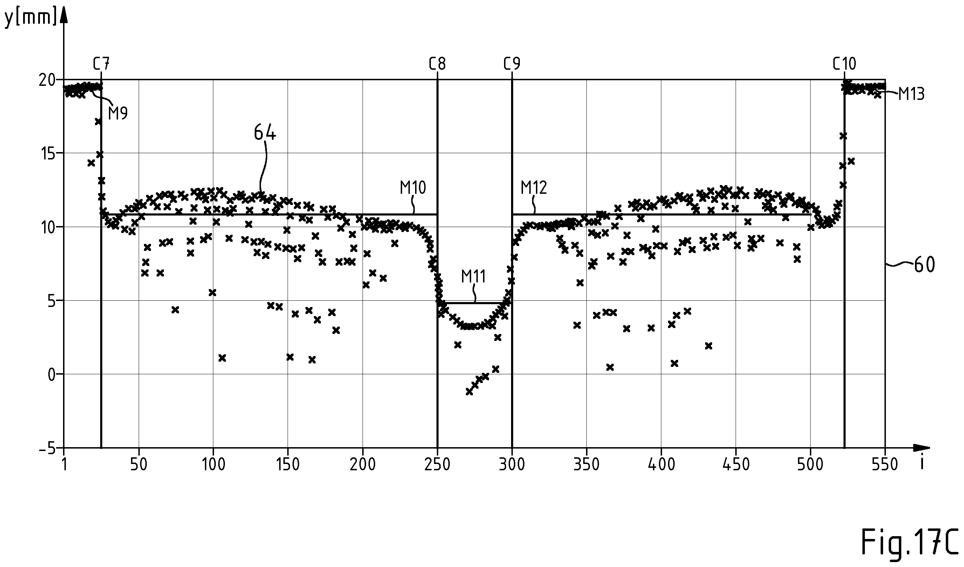

Die Fig. 17A, B und C zeigen die Berechnung der Wendepunkte 74 in den Signalen 72 aus der ersten Menge 64 und der zweiten Menge 66 von Projektionspunkten 62. Die vertikalen Linien zeigen jeweils die Koordinaten $C_1,...,C_{10}$ der detektierten Wendepunkte 74 im Signal 72, die horizontalen Linien die Mittelwerte $M_1,...,M_{13}$ der Teilsignale 76, 76'.

In der Fig. 17A wird anhand der durch die zweite Menge 66 von Projektionspunkten 62 beschriebenen unteren Kontur 66 das Optimierungsproblem (1) für vier Wendepunkte 74 gelöst, sodass die Summe der Varianzen der fünf Teilsignale 76, 76' minimiert wird. Die horizontale Achse zeigt den Index i des Projektionspunkts 62 aus der zweiten Menge 66 von Projektionspunkten 62, die zu Oberflächenpunkten 28 des unteren Fassungsrands 70 gehören, in der x-z-Ebene 60. Die vertikale Achse zeigt die z-Koordinate der Projektionspunkte 62.

Die Fig. 17B ist ein Ausschnitt des Signals 72 in der Fig. 17A, nämlich des Teils der zweiten Menge 66 von Projektionspunkten 62 im Intervall $[C_2, C_3]$, die auf der unteren Kontur 66 der projizierten Oberflächenpunkte 28 der Brücke liegen. Die horizontale Achse zeigt den Index i des Projektionspunkts 62 aus der zweiten Menge 66 von Projektionspunkten 62, die zu Oberflächenpunkten 28 des unteren Fassungsrands 70 gehören, in der x-z-Ebene 60. Die vertikale Achse zeigt die z-Koordinate der Projektionspunkte 62. Für diesen Signalausschnitt werden in einem nachfolgenden Schritt nochmals zwei Wendepunkte 74 detektiert.

Die Fig. 17C zeigt die Bestimmung von vier Wendepunkten 74 für die erste Menge 64 von Projektionspunkten 62 der oberen Kontur 64.

Die Zerlegung einer Instanz 30 des parametrischen Modells des Fassungsvorderteils kann z. B. durch den folgenden Parametersatz mit sechzehn Parameterwerten

$$Z = (x_1, x_2, x_3, x_{32}, x_4, x_5, x_6, x_7, x_{71}, x_8, x_9, z_1, z_2, z_{21}, z_3, z_4) \tag{2}$$

beschrieben werden:

- $x_1$: minimale Abszissen-Koordinate aller Projektionspunkte 62
- $x_9$: maximale Abszissen-Koordinate aller Projektionspunkte 62
- $z_1$: minimale Ordinaten-Koordinate aller Projektionspunkte 62
- $z_4$: maximale Ordinaten-Koordinate aller Projektionspunkte 62
- 

$$x_{5:} = \frac{x_1 + x_9}{2}$$

- $x_3$: Abszissen-Koordinate zu der minimalen Ordinaten-Koordinate in $[x_1, x_5]$
- $x_{32}$: Abszissen-Koordinate zu der maximalen Ordinaten-Koordinate in $[x_1, x_5]$
- $x_7$: Abszissen-Koordinate zu der minimalen Ordinaten-Koordinate in $[x_5, x_9]$
- $x_{71}$: Abszissen-Koordinate zu der maximalen Ordinaten-Koordinate in $[x_5, x_9]$
- $z_2$: $M_1$
- $z_{21}$: $M_5$
- $x_4$: $C_5$
- $x_6$: $C_6$
- $z_3$: $M_7$
- $x_2$: $C_7$

- $x_8$: $C_{10}$

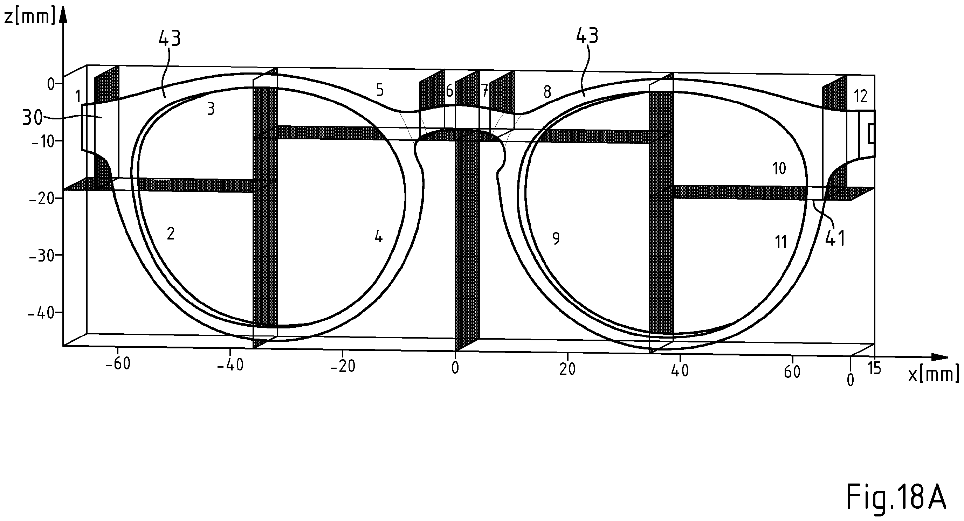

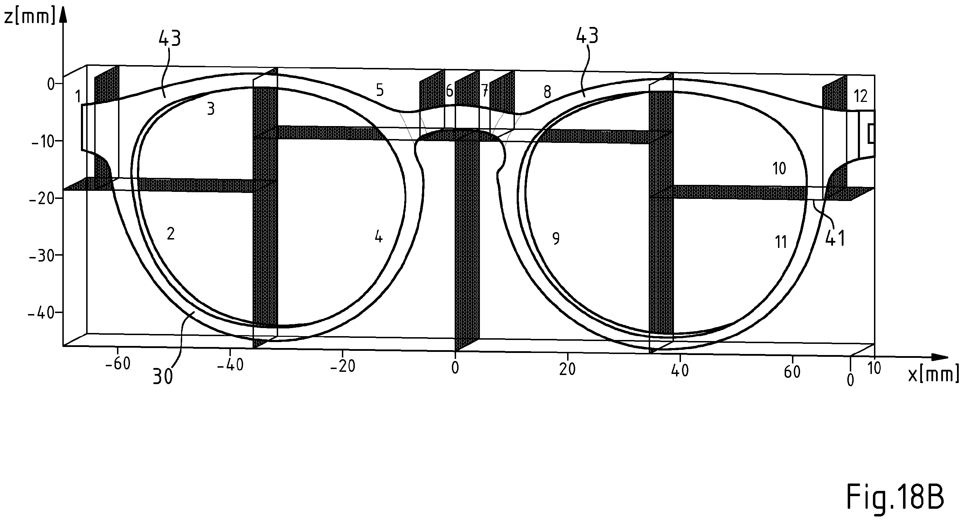

Die Fig. 18A zeigt die anhand des zuvor beschriebenen Algorithmus zur Detektion von Wendepunkten 74 ermittelte Zerlegung einer Instanz 30 eines parametrischen Ersatzmodells eines Fassungsvorderteils in zwölf Segmente 40. Die Fig. 18B zeigt die anhand desselben Algorithmus berechnete Zerlegung einer weiteren Instanz 30 des parametrischen Ersatzmodells eines Fassungsvorderteils in zwölf Segmente 40. Dabei sind alle Oberflächenpunkte 28, die innerhalb einer mit einer Ziffer gekennzeichneten Region liegen, Teil des gleichen Segments 40 mit Segmentgrenzen 41. Mit der gleichen Ziffer gekennzeichnete Segmente 40 der beiden Instanzen 30 in der Fig. 18A und der Fig. 18B entsprechen einander.

Die Fig. 19 zeigt die Zerlegung einer Instanz 30 eines CAD-Modells eines Fassungsbügels in zwei Segmente 40.

Da derselbe Zerlegungsalgorithmus auf alle Instanzen 30 des parametrischen Modells des wenigstens einen Brillenfassungselements 24 oder des parametrischen Ersatzmodells des wenigstens einen Brillenfassungselements 24 angewendet wird, kann jedem Segment 40 der einen Instanz 30 das entsprechende Segment 40 in den weiteren Instanzen 30 direkt zugeordnet werden. Anhand dieser Korrespondenzen können die parametrischen Deformationsabbildungen zur Abbildung der Basis-Segment-Instanzen 39 auf weitere entsprechende Segment-Instanzen 43 ermittelt werden.

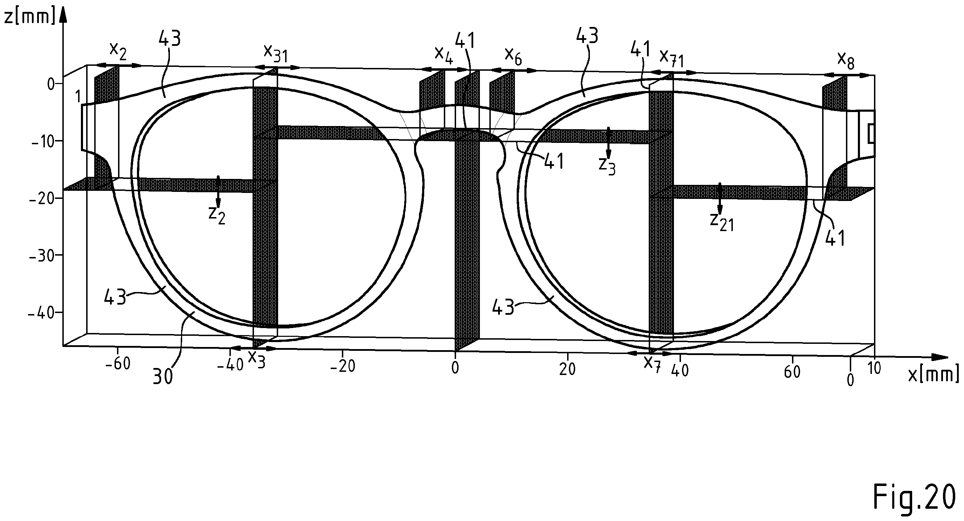

Um die Genauigkeit der parametrischen Deformationsabbildungen zu verbessern, kann, wie in der Fig. 20 gezeigt, die Segmentierung der Instanzen 30 durch Variation der Parameterwerte $Z$ in (2) optimiert werden. Damit kann die Abbildbarkeit verschiedener Segment-Instanzen 43 zu demselben Segment 40 aufeinander verbessert werden.

Alternativ zu der Detektion von Wendepunkten 74 in Signalen 72 von Fassungsrändern 68, 70 zur Bestimmung des Parametersatzes $Z$ in (2) zur Zerlegung von Instanzen 30 in Segmente 40 aus der Menge von Segmenten 40 können Mesh-Segmentierungsverfahren, multivariate Anpassungs-Verfahren, Skelettierungsverfahren und/oder maschinelle Lernverfahren verwendet werden.

Um eine Instanz 30 eines parametrischen Modells eines Brillenfassungselements 24 anhand eines parametrischen Ersatzmodells des Brillenfassungselements 24 darstellen zu können, müssen nach der Zerlegung der Instanz 30 in die Segmente 40 aus der Menge von Segmenten 40 für jedes dieser Segmente 40 die Parameterwerte der zugehörigen parametrischen Deformationsabbildungen bestimmt werden.

Dafür können Algorithmen zur Ausrichtung von 3D-Objekten verwendet werden, die Abstände zwischen Punktewolken minimieren, z. B. ein Iterative Closest Point (ICP) Algorithmus wie in dem Artikel "S. Rusinkiewicz and M. Levoy, Effcient variants of the ICP algorithm, Proceedings of the Third International Conference on 3-D Digital Imaging and Modeling, S. 145-182, 2001" beschrieben, auf den hiermit vollumfänglich Bezug genommen und dessen Offenbarung in die Beschreibung dieser Erfindung einbezogen wird.

Es kann angenommen werden, dass sich bei einer Änderung der Parameterwerte der parametrischen Deformationsabbildungen die Triangulierung der Oberflächenpunkte 28 in Form des Dreiecksnetzes, insbesondere die Topologie und Vernetzung der Dreiecksstruktur, nicht ändert. Die Algorithmen zur Bestimmung der Parameterwerte der parametrischen Deformationsabbildungen, wie z. B. die ICP-Algorithmen, können dann direkt auf den Oberflächenpunkten 28 des Meshs 26 operieren. Dies spart Rechenzeit.

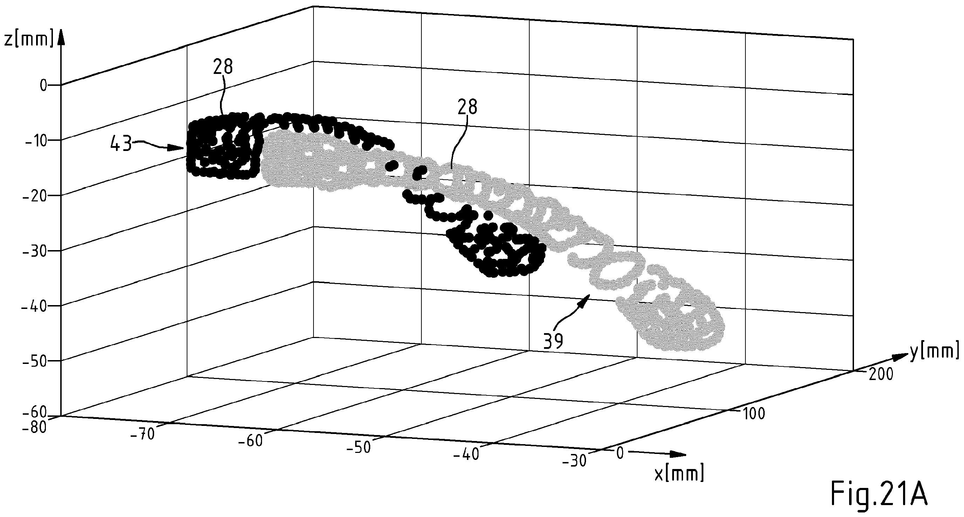

Die Fig. 21A zeigt die Deformation einer Basis-Segment-Instanz 39 eines Segments 40 eines parametrischen Modells eines Fassungsbügels anhand des ICP-Algorithmus, sodass der Abstand der Oberflächenpunkte 28 des Meshs 26 dieser Basis-Segment-Instanz 39 von den Oberflächenpunkten 28 des Meshs 26 des entsprechenden Segments 40 einer weiteren Instanz 30 des parametrischen Modells des Fassungsbügels möglichst gering ist.

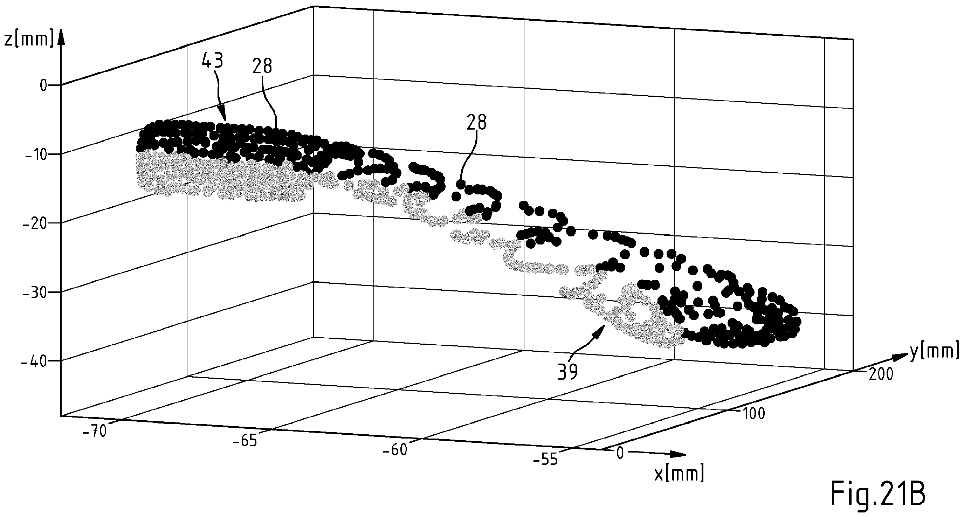

Die Fig. 21A zeigt die Oberflächenpunkte 28 des Meshs 26 der Basis-Segment-Instanz 39 und der weiteren Segment-Instanz 43 in einem Koordinatensystem 32 vor der Anwendung des ICP-Algorithmus, die Fig. 21B zeigt die beiden Segmente 40 nach 18 Iterationen des Algorithmus.

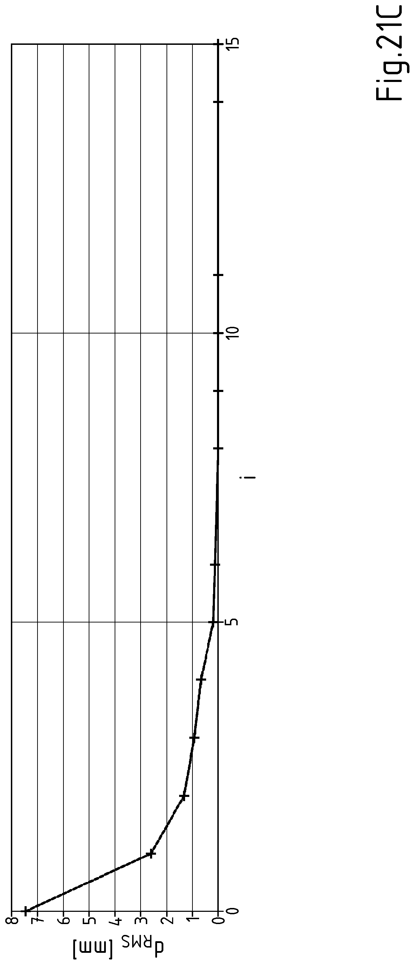

Die Fig. 21C zeigt den Verlauf der Wurzel der mittleren Fehlerquadratsumme (root mean square error) der kürzesten Abstände der Oberflächenpunkte 28 der Basis-Segment-Instanz 39 und der weiteren Segment-Instanz 43 voneinander.

Für manche Brillenfassungselemente 24, z. B. für die Fassungsbügel, können die parametrischen Deformationsabbildungen für die Segmente 40 besonders einfach gewählt werden, z. B. lediglich als Kombination einer Rotationsmatrix und eines Translationsvektors. Die Parameterwerte können dann anhand des ICP-Algorithmus bestimmt werden.

Als parametrische Deformationsabbildungen können hier Abbildungen der Form

$$f\colon \mathbb{R}^3 \to \mathbb{R}^3,$$

$$f(x) = R \cdot x + t,$$

$$R \in SO(3), t \in R^3$$

gewählt werden, wobei *SO*(3) die spezielle orthogonale Gruppe aller Rotationen um den Ursprung im dreidimensionalen Euklidischen Raum bezeichnet. Dabei wird folgendes Optimierungsproblem iterativ gelöst, das die mit Gewichten $w_i$ gewichtete Summe der Abstände der Oberflächenpunkte $p_i$ des Meshs 26 einer Basis-Segment-Instanz 39 von den zu $p_i$ nächstliegenden Oberflächenpunkten $q_i$ des Meshs 26 des entsprechenden Segments 40 der weiteren Instanz 30 minimiert:

$$(R,t) = \min_{R \in SO(3), t \in R^3} \{\textstyle\sum_{i=1}^{N} w_i \|(R * p_i + t) - q_i\|\}. \qquad (3)$$

Die Gewichte können als $w_i$ = 1 gewählt werden. Alternativ sind auch andere Gewichte anwendbar. Beispielsweise kann das Gewicht $w_i$ zu den Punkten $p_i$ und $q_i$ anhand des Winkels zwischen den an diesem Punkt vorliegenden Oberflächennormalen bestimmt werden:

$$w_i = p_i \cdot q_i$$

Die Oberflächennormalen zu einem Punkt können aus den nächsten Nachbarn dieses Punkts in der Punktewolke geschätzt werden. Diese Art von Gewichtung ist z. B. in dem oben genannten Artikel zu ICP-Algorithmen beschrieben.

Alternativ sind auch andere ICP-Varianten anwendbar, wie z. B. in dem Artikel ″Paul J. Besl und Neil D.McKay, A Method for Registration of 3-D Shapes, IEEE Transactions on Pattern Analysis and Machine Intelligence. Band 14, Ausgabe 2, 1992″ beschrieben, auf den hiermit vollumfänglich Bezug genommen und dessen Offenbarung in die Beschreibung dieser Erfindung einbezogen wird.

Von Vorteil für die Geschwindigkeit des Verfahrens ist die Verwendung des Punkt zu Ebenen ICP Algorithmus, wie er z. B. in dem Artikel ″Kok-Lim Low, Linear Least-Squares Optimization for Point-to-Plane ICP Surface Registration, Department of Computer Science University of North Carolina at Chapel Hill, Februray 2004″ bechrieben ist, auf den hiermit vollumfänglich Bezug genommen und dessen Offenbarung in die Beschreibung dieser Erfindung einbezogen wird. Dabei wird nicht der Abstand zwischen den Oberflächenpunkten der Instanzen minimiert, sondern der Abstand zwischen den Oberflächenpunkten einer Instanz und den Tangentialebenen an den nächsten Oberflächenpunkten der anderen Instanz.

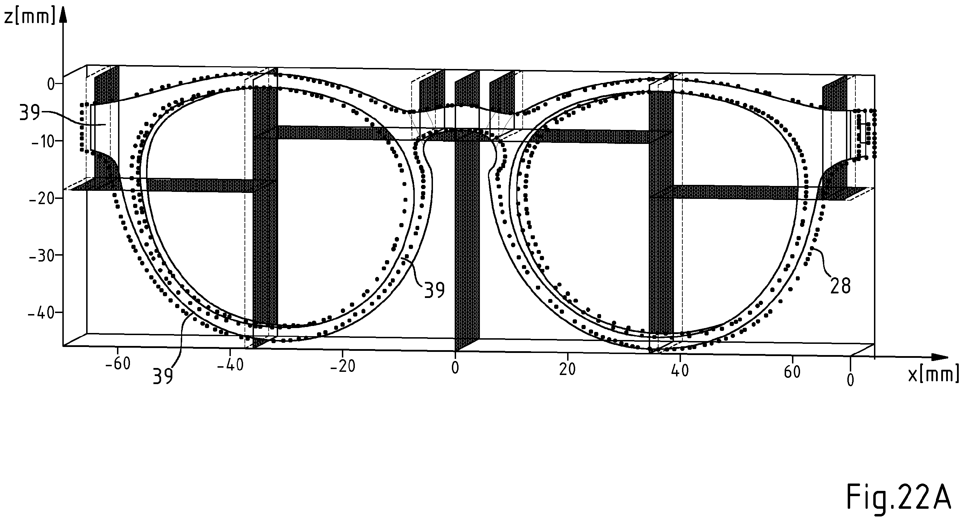

Die Fig. 22A zeigt ein Beispiel für die Bestimmung der Parameterwerte der parametrischen Deformationsabbildungen für die verschiedenen Basis-Segment-Instanzen 39 eines parametrischen Modells des Fassungsvorderteils. Dabei wird die Abweichung der Oberflächenpunkte 28 des Meshs 26 der Basis-Segment-Instanzen 39 von den nächstliegenden Oberflächenpunkten 28 des Meshs 26 der Segmente 40 der weiteren Instanz 30 anhand des Optimierungsproblems (3) minimiert.

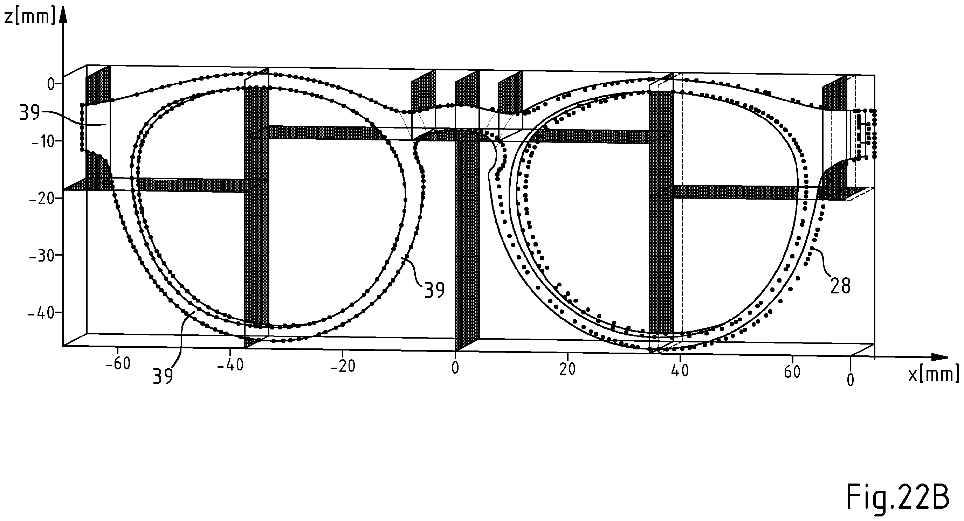

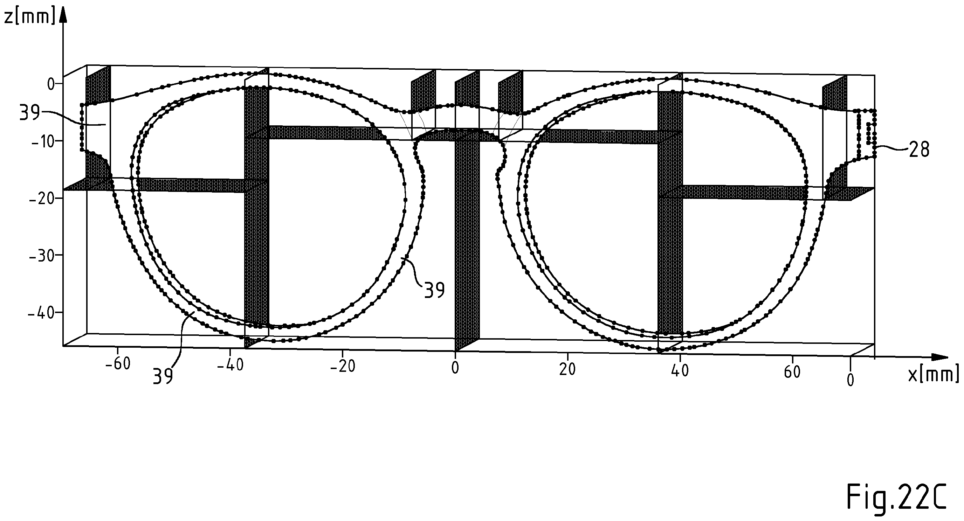

Die Fig. 22A zeigt die Basis-Segment-Instanzen 39 und die Oberflächenpunkte 28 der weiteren Instanz 30 vor Anwendung des ICP-Algorithmus. Die Fig. 22B zeigt die minimierte Abweichung für die Segmente 40 mit Ziffern 1 bis 6, die Fig. 22C für alle Segmente 40 nach Bestimmung der Parameterwerte der Deformationsabbildungen.

Alternativ zu den ICP-Algorithmen können auch andere Deformationsverfahren zur Bestimmung der Parameterwerte der parametrischen Deformationsabbildungen verwendet werden, insbesondere Mesh Editing Verfahren. Hierbei wird eine Oberfläche anhand von Kontrollpunkten durch das Lösen eines dünnbesetzten Matrixproblems deformiert. Beispiele für Mesh Editing Verfahren sind das Laplacian Surface Editing, das z. B. in dem Artikel ″Laplacian Surface Editing, O Sorkine, D. Cohen-Or, Eurographics Symposium on Geometry Processing, 2004″ beschrieben ist, oder das Poisson-Surface Editing, welches im Artikel "Mesh Editing with Poisson-Based Gradient Field Manipulation, Yizhou Yu et al., ACM SIGGRAPH 2004 "

Von Vorteil ist die Integration von Symmetrieannahmen bezüglich einzelner Segmente 40 des parametrischen Modells des wenigstens einen Brillenfassungselements 24, z. B. des linken und des rechten Fassungsbügels, in das parametrische Ersatzmodell des wenigstens einen Brillenfassungselements 24.

Im Falle einer eher geringen Variation des parametrischen Modells eines Brillenfassungselements 24 kann die Komplexität des parametrischen Ersatzmodells durch Verwendung einer größeren Menge an Basisinstanzen 38 anstatt von parametrischen Deformationsabbildungen verringert werden.

Das ermittelte parametrische Ersatzmodell für das parametrische Modell des Fassungsvorderteils kann die folgenden Elemente mit Parametern enthalten:

- Die Anzahl der Segmente 40 des parametrischen Modells des Fassungsvorderteils;
- Die Meshes 26 der wenigstens einen Basis-Segment-Instanz 39 des Fassungsvorderteils;
- den Parametersatz $Z$ in (2) enthaltend die sechzehn Parameter, welche die Grenzen der zwölf Segmente 40 beschreiben;
- 12 Rotationsmatrizen und 12 Translationsvektoren mit zu bestimmenden Parametern, welche die parametrischen Deformationsabbildungen für jedes Segment 40 der Basis-Segment-Instanzen 39 beschreiben;
- Parameter eines Nachverarbeitungsschritts 46.

Der die Zerlegung des parametrischen Modells beschreibende Parametersatz $Z$ in (2) ist dabei optional, da er anhand des Algorithmus zur Zerlegung jederzeit neu berechnet werden und somit nicht als Parameter des parametrischen Ersatzmodells mit abgespeichert werden muss. Dies spart Übertragungszeit und Speicherplatz. Das zusätzliche Abspeichern spart jedoch Rechenzeit. Für eine spezielle Instanz 30 des parametrischen Ersatzmodells des Fassungsvorderteils genügt es, die folgenden Parameterwerte abzuspeichern:

- den Index der jeweils ausgewählten Basis-Segment-Instanz 39 für jedes Segment 40 des parametrischen Ersatzmodells, falls mehrere Basis-Segment-Instanzen 39 zu einem Segment 40 vorliegen;
- die Parameterwerte der parametrischen Deformationsabbildungen.

Diese Parameterwerte können auf ein Videozentriergerät übertragen werden. Dort kann dann die spezielle Instanz 30 lediglich anhand des jeweiligen Index der Basis-Segment-Instanz 39 und der Parameterwerte der parametrischen Deformationsabbildungen sowie des dort abgespeicherten parametrischen Ersatzmodells des wenigstens einen Brillenfassungselements 24 wiederhergestellt werden. Somit ist keine Übertragung und Speicherung des gesamten Meshs 26 der speziellen Instanz 30 oder des parametrischen Ersatzmodells des wenigstens einen Brillenfassungselements 24 auf das Videozentriergerät notwendig. Die Verwendung des parametrischen Ersatzmodells spart somit Speicherplatz und Übertragungszeit.

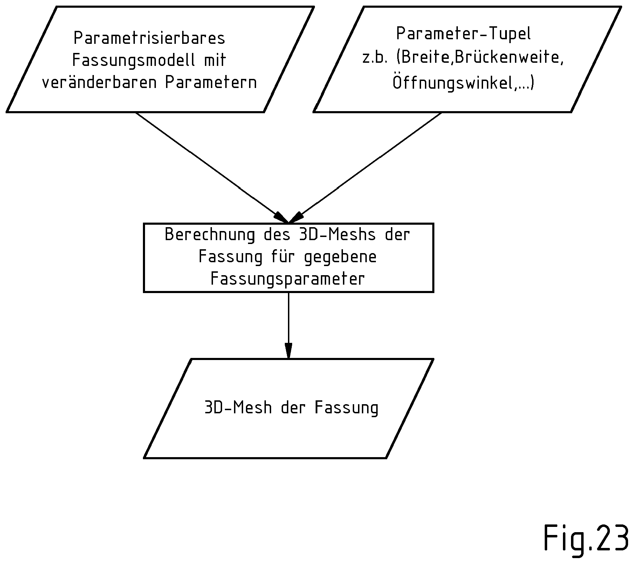

Anhand des parametrischen Ersatzmodells kann dann durch Auswahl von Parameterwerten ein Mesh 26 eines Brillenfassungselements 24, wie in der Fig. 23 gezeigt, erzeugt werden.

Um Sprungstellen 78 an Segmentgrenzen 41 zu vermeiden, die aufgrund der für jedes Segment 40 unabhängig durchgeführten Berechnung der Parameterwerte für die parametrischen Deformationsabbildungen entstehen können, können Glättungsverfahren angewendet werden, wie z. B. das Delta Mush Verfahren, das in dem Artikel "Delta Mush: Smoothing Deformations while Preserving Detail, Joe Mancewicz, Matt L. Derksen, Hans Rijpkema, Cyrus A. Wilson, Proceedings oft he 4th Symposium on Digital Production, 2014" beschrieben ist, auf den hiermit vollumfänglich Bezug genommen und dessen Offenbarungsgehalt in die Beschreibung dieser Erfindung mit einbezogen wird. Das Delta Mush Verfahren hat den Vorteil gegenüber anderen Glättungsverfahren, dass sich das Mesh 26 durch die Glättung nur geringfügig verändert, sodass auch mit dem parametrischen Ersatzmodell des wenigstens einen Brillenfassungselements 24 Berechnungen, die eine besonders hohe Genauigkeit erfordern, wie z. B. eine virtuelle Zentrierung, möglich sind.

Die Fig. 24A, die Fig. 24B und die Fig. 24C erläutern die Anwendung des Delta Mush Verfahrens auf die Segmentgrenzen 41 an einer Instanz 30 eines parametrischen Ersatzmodells einer Anschlussstelle. Die Fig. 24A zeigt eine Instanz 30 des parametrischen Ersatzmodells der Anschlussstelle mit Sprungstellen 78 an den Segmentgrenzen 41. Die Fig. 24B zeigt die Segmente 40 ohne Sprungstellen 78 nach der Glättung durch das Delta Mush Verfahren. Die Fig. 24C zeigt zum Vergleich die ursprüngliche Instanz 30 des parametrischen Modells der Anschlussstelle.

Ein erfindungsgemäßes Computerprogrammprodukt enthält ein Computerprogramm mit Programmcode zur Durchführung der vorstehend angegebenen Verfahrensschritte, wenn das Computerprogramm in eine Rechnereinheit geladen und/oder in einer Rechnereinheit durchgeführt wird.

Eine Vorrichtung zur Individualisierung und Anpassung eines parametrischen Modells eines Brillenfassungselements an den Kopf eines Brillenträgers enthält eine Rechnereinheit, in die ein computerimplementiertes Verfahren zur Anpassung des parametrischen Modells des Brillenfassungselements an eine Darstellung des Kopfes in einem Koordinatensystem geladen ist.

Eine Vorrichtung zur Darstellung und/oder Kompression einer gegebenen Instanz eines parametrischen Modells eines Brillenfassungselements enthält eine Rechnereinheit mit einem Speicher, in die ein computerimplementiertes Verfahren zur Darstellung und/oder Kompression der gegebenen Instanz in dem Speicher der Rechnereinheit geladen ist.

Ein erfindungsgemäßes System mit einer Einrichtung zum Herstellen eines in einem vorstehend angegebenen Verfahren zur Individualisierung eines Brillenfassungselements individualisiertes Brillenfassungselement oder zum Einschleifen von Brillengläsern in ein in einem vorstehend angegebenen Verfahren zur Individualisierung eines Brillenfassungselements individualisiertes Brillenfassungselement verwendet den wenigstens einen ermittelten Parameterwert des parametrischen Ersatzmodells.

Zusammenfassend ist insbesondere Folgendes festzuhalten: Die Erfindung betrifft ein Verfahren 10, 10' zur Ermittlung eines parametrischen Ersatzmodells eines Brillenfassungselements 24 zu einem parametrischen Modell des Brillenfassungselements 24 zur Anpassung dieses parametrischen Ersatzmodells an den Kopf eines Brillenträgers. Dabei wird wenigstens eine Basisinstanz 38 bereitgestellt durch Erstellen wenigstens einer Instanz 30 des parametrischen Modells des Brillenfassungselements 24 in Form einer Realisierung des parametrischen Modells des wenigstens einen Brillenfassungselements 24 anhand einer Menge von konkreten Parameterwerten. Zu der wenigstens einen Basisinstanz 38 wird wenigstens eine parametrische Deformationsabbildung ermittelt, welche die wenigstens eine Basisinstanz 38 auf Instanzen 30 des parametrischen Modells abbildet, wobei das parametrische Ersatzmodell zumindest aus der wenigstens einen Basisinstanz 38 und aus der wenigstens einen parametrischen Deformationsabbildung bestimmt wird. Alternativ kann zu dem parametrischen Modell des Brillenfassungselements 24 eine Menge von Segmenten 40 bestimmt werden. Zu jedem Segment 40 werden wenigstens eine Basis-Segment-Instanz 39 sowie wenigstens eine parametrische Deformationsabbildung ermittelt. Die wenigstens eine parametrische Deformationsabbildung bildet dann wenigstens eine Basis-Segment-Instanz 39 auf weitere Segment-Instanzen 43 des parametrischen Modells ab, wobei das parametrische Ersatzmodell zumindest aus der Menge von Segmenten 40 sowie aus der wenigstens einen Basis-Segment-Instanz 39 und der wenigstens einen parametrischen Deformationsabbildung für jedes Segment 40 aus der Menge von Segmenten 40 bestimmt wird.

**Bezugszeichenliste**

| | |
|---|---|
| 10 | Verfahren |
| 12 | Verfahrensschritt: Vorgeben von Instanzen des parametrischen Modells des Brillenfassungselements |
| 13 | Verfahrensschritt: Zerlegen des parametrischen Modells des Brillenfassungselements in eine Menge von Segmenten |
| 14 | Verfahrensschritt: Ermitteln wenigstens einer Basisinstanz |
| 15 | Verfahrensschritt: Zerlegen der vorgegebenen Instanzen in die Segmente aus der Menge von Segmenten |
| 16 | Verfahrensschritt: Ermitteln wenigstens einer parametrischen Deformationsabbildung |
| 17 | Verfahrensschritt: Auswahl von Segment-Instanzen aus den zerlegten vorgegebenen Instanzen |
| 18 | Iteration der Verfahrensschritte zur Optimierung des parametrischen Ersatzmodells |
| 20 | Verfahrensschritt: Ermitteln wenigstens einer Basis-Segment-Instanz zu jedem Segment |
| 21 | Verfahrensschritt: Ermitteln wenigstens einer parametrischen Deformationsabbildung zu jeder Basis-Segment-Instanz |
| 22 | CAD-Modell |
| 24 | Brillenfassungselement |
| 26 | Mesh |
| 28 | Oberflächenpunkte |
| 30 | Instanz |
| 32 | Koordinatensystem |
| 34 | Symmetrieebene |
| 36 | Schwerpunkt |
| 38 | Basisinstanz |
| 39 | Basis-Segment-Instanz |
| 40 | Segment |
| 41 | Segmentgrenze |
| 42 | Datenbank |
| 43 | Segment-Instanz |
| 44 | Vorverarbeitungsschritt |
| 46 | Nachverarbeitungsschritt |
| 48 | Verfahrensschritt: Erzeugung eins Kopfmodells |
| 49 | Verfahrensschritt: Auswählen einer Basisinstanz |
| 50 | Verfahrensschritt: Anpassung des parametrischen Ersatzmodells an den Kopf eines Brillenträgers |
| 52 | Verfahrensschritt: Virtuelles Aufsetzen und Rendering einer Instanz eines parametrischen Modells |
| 54 | Baumstruktur |
| 56, 56' | Knoten |
| 58 | Unterbaum |
| 60 | Ebene |
| 62 | Projektionspunkte |
| 64 | erste Menge von Projektionspunkten |
| 66 | zweite Menge von Projektionspunkten |

| | |
|---|---|
| 68 | oberer Fassungsrand |
| 70 | unterer Fassungsrand |
| 72 | Signal |
| 74 | Wendepunkt |
| 76, 76' | Teilsignal |
| 78 | Sprungstelle |
| $C_1,...,C_{10}$ | Koordinaten detektierter Wendepunkte |
| $M_1,...,M_{13}$ | Mittelwerte von Teilsignalen zwischen Wendepunkten |
| f, $f_i$ | parametrische Deformationsabbildung |
| $\alpha$, $\alpha_i$ | Parameter der parametrischen Deformationsabbildungen |
| b | Basisinstanz |
| $b_i$ | Basis-Segment-Instanz |

**Patentansprüche**

1. Computerimplementiertes Verfahren (10) zur Ermittlung eines wenigstens einen Parameter aufweisenden parametrischen Ersatzmodells zu einem parametrischen Modell eines Brillenfassungselements (24), wobei mehrere Instanzen (30) des parametrischen Modells in Form von Realisierungen des parametrischen Modells mittels konkreter Parameterwerte vorgegeben werden, aus den vorgegebenen Instanzen (30) wenigstens eine Basisinstanz (38) und wenigstens eine parametrische Deformationsabbildung zu der wenigstens einen Basisinstanz (38) ermittelt wird, wobei die wenigstens eine parametrische Deformationsabbildung die wenigstens eine Basisinstanz (38) auf Instanzen (30) des parametrischen Modells abbildet, und wobei das parametrische Ersatzmodell zumindest aus der wenigstens einen Basisinstanz (38) und aus der wenigstens einen parametrischen Deformationsabbildung bestimmt wird.

2. Computerimplementiertes Verfahren (10) zur Ermittlung eines wenigstens einen Parameter aufweisenden parametrischen Ersatzmodells zu einem parametrischen Modell eines Brillenfassungselements (24), wobei mehrere Instanzen (30) des parametrischen Modells in Form von Realisierungen des parametrischen Modells mittels konkreter Parameterwerte vorgegeben werden, zu dem parametrischen Modell des Brillenfassungselements (24) eine Menge von Segmenten (40) bestimmt wird, die vorgegebenen Instanzen (30) in die Segmente (40) aus der Menge von Segmenten (40) zerlegt werden, zu jedem Segment (40) aus der Menge von Segmenten (40) Segment-Instanzen (43) erzeugt werden, indem Instanzen (30) dieses Segments (40) aus den zerlegten vorgegebenen Instanzen (30) ausgewählt werden, aus diesen Segment-Instanzen (43) wenigstens eine Basis-Segment-Instanz (39) und wenigstens eine parametrische Deformationsabbildung zu der wenigstens einen Basis-Segment-Instanz (39) ermittelt wird, wobei die wenigstens eine parametrische Deformationsabbildung die wenigstens eine Basis-Segment-Instanz (39) auf Segment-Instanzen (43) des parametrischen Modells abbildet, und wobei das parametrische Ersatzmodell zumindest aus der Menge von Segmenten (40) sowie aus der wenigstens einen Basis-Segment-Instanz (39) und der wenigstens einen parametrischen Deformationsabbildung für jedes Segment (40) aus der Menge von Segmenten (40) bestimmt wird.

3. Computerimplementiertes Verfahren (10) zur Ermittlung eines wenigstens einen Parameter aufweisenden parametrischen Ersatzmodells zu einem parametrischen Modell eines Brillenfassungselements (24), wobei mehrere Instanzen (30) des parametrischen Modells in Form von Realisierungen des parametrischen Modells mittels konkreter Parameterwerte vorgegeben werden, zu dem parametrischen Modell des Brillenfassungselements (24) eine Menge von Segmenten (40) bestimmt wird, die vorgegebenen Instanzen (30) in die Segmente (40) aus der Menge von Segmenten (40) zerlegt werden, zu jedem Segment (40) aus der Menge von Segmenten (40) Segment-Instanzen (43) erzeugt werden, indem Instanzen (30) dieses Segments (40) aus den zerlegten vorgegebenen Instanzen (30) ausgewählt werden, zu jedem Segment (40) in einem computerimplementierten Verfahren nach Anspruch 1 ein wenigstens einen Parameter aufweisendes parametrisches Ersatzmodell als Segment-Ersatzmodell bestimmt wird, wobei als vorgegebene Instanzen dabei die zu einem jeden Segment gehörenden Segment-Instanzen (43) verwendet werden, und wobei das parametrische Ersatzmodell zumindest aus der Menge von Segmenten (40) sowie aus den wenigstens einen Parameter aufweisenden parametrischen Segment-Ersatzmodellen bestimmt wird.

**4.** Verfahren nach Anspruch 2 oder 3, **dadurch gekennzeichnet, dass** die Segmente (40) aus der Menge von Segmenten (40) als statisch, beweglich oder deformierbar gekennzeichnet werden.

**5.** Verfahren nach Anspruch 4, **dadurch gekennzeichnet, dass** die parametrischen Deformationsabbildungen zu den als statisch gekennzeichneten Segmenten (40) lineare Abbildungen sind und/oder dass die parametrischen Deformationsabbildungen der als beweglich gekennzeichneten Segmente (40) affine Abbildungen sind und/oder dass die parametrischen Deformationsabbildungen der als deformierbar gekennzeichneten Segmente (40) anhand von Bezier-Kurven, Splines oder NURBS approximiert werden.

**6.** Verfahren nach einem der Ansprüche 2 bis 5, **dadurch gekennzeichnet, dass** bei der Zerlegung von Instanzen (30) des parametrischen Modells des Brillenfassungselements (24) in Segmente (40) aus der Menge von Segmenten (40) ein Verfahren zur Erkennung von Wendepunkten (74) in Signalen (72) und/oder ein Mesh-Segmentierungsverfahren und/oder multivariate Anpassungs-Verfahren und/oder Skelettierungsverfahren und/oder ein maschinelles Lernverfahren angewendet wird;
und/oder
dass die Segmente (40) aus der Menge von Segmenten (40) derart hierarchisch in einer Baumstruktur (54) angeordnet sind, dass die in der Baumstruktur (54) verbundenen Knoten (56, 56') zu Segmenten (40) mit einer gemeinsamen Schnittkante oder -fläche in dem parametrischen Modell gehören;
und/oder
dass jedes Segment (40) in der Baumstruktur (54) relativ zu seinem Vorgängersegment in einem Koordinatensystem (32) positioniert und orientiert ist
und/oder
dass Instanzen (30) des parametrischen Ersatzmodells in Form von Realisierungen des parametrischen Ersatzmodells mittels konkreter Parameterwerte anhand eines Algorithmus zur Vermeidung von Sprungstellen (78) an Segmentgrenzen (41) nachverarbeitet werden.

**7.** Verfahren nach einem der Ansprüche 1 bis 6, **dadurch gekennzeichnet, dass** zu dem parametrischen Ersatzmodell des Brillenfassungselements (24) zusätzliche Merkmale aus der Gruppe umfassend Ohrauflagepunkte, Nasenauflagepunkte, Auflagekurven der Enden der Fassungsbügel, 3D-Glasebenen, 3D-Boxen, Nasenpads bestimmt werden;
und/oder
dass die parametrischen Deformationsabbildungen aus der Gruppe umfassend affine Abbildungen, Polynome, polynomiale Flächen, Bezier-Kurven, Splines oder NURBS stammen;
und/oder
dass Verfahrensschritte zur Ermittlung des parametrischen Ersatzmodells iteriert werden.

**8.** Verfahren nach einem der Ansprüche 1 bis 7, **dadurch gekennzeichnet, dass** zur Bestimmung des parametrischen Ersatzmodells ein Kriterium aus der Gruppe umfassend gewichtete Summe, Durchschnitt, Maximum und Quantile der Verteilung der Abweichungen zwischen Oberflächen der vorgegebenen Instanzen (30) des parametrischen Modells und Oberflächen aller anhand konkreter Parameterwerte erzeugbarer Instanzen (30) des parametrischen Ersatzmodells des wenigstens einen Brillenfassungselements (24) optimiert,
und/oder
dass die vorgegebenen Instanzen (30) des parametrischen Modells wenigstens teilweise mittels eines Algorithmus zur Ausbesserung von Fehlern und/oder zur Verbesserung des visuellen Eindrucks für den Brillenträger und/oder zur Glättung nachverarbeitet werden.

**9.** Bereitstellen eines in einem Verfahren nach einem der Ansprüche 1 bis 8 ermittelten parametrischen Ersatzmodells in einem Datenformat, das sich von dem des parametrischen Modells unterscheidet.

**10.** Computerimplementiertes Verfahren zur Individualisierung eines Brillenfassungselements (24) durch Anpassung eines parametrischen Modells eines Brillenfassungselements (24) an den Kopf eines Brillenträgers anhand eines in einem Verfahren nach einem der Ansprüche 1 bis 8 ermittelten oder anhand von Anspruch 9 bereitgestellten, wenigstens einen Parameter aufweisenden parametrischen Ersatzmodells des Brillenfassungselements (24), **gekennzeichnet durch**
das Bestimmen einer Darstellung des Kopfes in einem Koordinatensystem (32) in einer Rechnereinheit; und
das Ermitteln eines Parameterwerts für den wenigstens einen Parameter des parametrischen Ersatzmodells des Brillenfassungselements (24), sodass die anhand dieses wenigstens einen Parameterwerts erzeugte Instanz (30) des parametrischen Ersatzmodells des Brillenfassungselements (24) an den Kopf angepasst ist.

**11.** Computerimplementiertes Verfahren zur Darstellung und/oder Kompression einer gegebenen Instanz (30) eines parametrischen Modells eines Brillenfassungselements (24) anhand eines in einem Verfahren nach einem der Ansprüche 1 bis 8 ermittelten oder anhand des Verfahrens nach Anspruch 9 bereitgestellten, wenigstens einen Parameter aufweisenden parametrischen Ersatzmodells des Brillenfassungselements (24) in einer Rechnereinheit **gekennzeichnet durch**

das Ermitteln jeweils eines Parameterwerts für den wenigstens einen Parameter des parametrischen Ersatzmodells des Brillenfassungselements (24) durch Optimieren eines Kriteriums aus der Gruppe umfassend gewichtete Summe, Durchschnitt, Maximum und Quantile der Verteilung der Abweichungen zwischen Oberflächen der gegebenen Instanz (30) des parametrischen Modells und Oberflächen der anhand dieses wenigstens einen Parameterwerts erzeugten Instanz (30) des parametrischen Ersatzmodells; und

das Speichern des wenigstens einen ermittelten Parameterwerts in einem Speicher der Rechnereinheit.

**12.** Computerprogramm mit Programmcode zur Durchführung aller Verfahrensschritte, die in einem der Ansprüche 1 bis 11 angegeben sind, wenn das Computerprogramm in eine Rechnereinheit geladen und/oder in einer Rechnereinheit durchgeführt wird.

**13.** Vorrichtung zur Individualisierung und Anpassung eines parametrischen Modells eines Brillenfassungselements (24) an den Kopf eines Brillenträgers mit einer Rechnereinheit, die ein computerimplementiertes Verfahren nach Anspruch 10 zur Anpassung des parametrischen Modells des Brillenfassungselements (24) an eine Darstellung des Kopfes in einem Koordinatensystem (32) in der Rechnereinheit enthält.

**14.** Vorrichtung zur Darstellung und/oder Kompression einer gegebenen Instanz (30) eines parametrischen Modells eines Brillenfassungselements (24) mit einer einen Speicher aufweisenden Rechnereinheit, wobei die Rechnereinheit ein computerimplementiertes Verfahren nach Anspruch 11 zur Darstellung und/oder Kompression der gegebenen Instanz in dem Speicher der Rechnereinheit enthält.

**15.** System mit einer Einrichtung zum Herstellen eines in einem Verfahren nach Anspruch 10 individualisierten Brillenfassungselements (24) oder zum Einschleifen von Brillengläsern in ein nach Anspruch 10 individualisiertes Brillenfassungselement (24) unter Verwendung des wenigstens einen ermittelten Parameterwerts des parametrischen Ersatzmodells.

Fig.1

Fig.2

EP 3 809 304 A1

Fig.3

10'

18 — Iteration

Vorgeben von Instanzen 30 des parametrischen Modells des Brillenfassungselements 24
— 12

Bestimmen einer Menge von Segmenten 40 des parametrischen Modells des Brillenfassungselements 24
— 13

Zerlegen der vorgegebenen Instanzen 30 in die Segmente 40 aus der Menge von Segmenten 40
— 15

Auswahl von Segment-Instanzen 43 aus den zerlegten vorgegebenen Instanzen 30
— 17

Ermitteln wenigstens einer Basis-Segment-Instanz 39 zu jedem Segment 40
— 20

Ermitteln wenigstens einer parametrischen Deformationsabbildung $f_i(b_i, \alpha_i)$ zu jeder Basis-Segment-Instanz 39
— 21

30  30  30  30

24  40

43  43

43  43  43  43

39  39

39  $\xrightarrow{f_i(b_i, \alpha_i)}$  43

Fig.4

Fig.5

Fig.6

Fig.7

Fig.8

EP 3 809 304 A1

Fig.9

$$m = \frac{1}{k}\sum_{j=1}^{k} I_j$$

$$f(b,\alpha) = b + \sum_{j=1}^{r} \alpha_j \nu_j$$

Mesh Datenbank des Fassungsherstellers

Vorbereitung der Datenbank: Ausbessern von visuellen oder topologischen Mesh Fehlern

Identifizierung relevanter Fassungsparameter des Herstellers

Meshes des Herstellers liegen Partitioniert vor?

Ja / Nein

**Nein:**

Festlegen Basismodell Fassung
→ Optimierung →
Segmentierung Fassung
→ Optimierung →
Deformation Fassung

**Ja:**

Festlegen Basismodell Bügelteil
→ Optimierung →
Segmentierung der Bügelteile
→ Optimierung →
Deformation/ Ausrichtung Bügelteile

Festlegen Basismodell Fassungsvorderteil
→ Optimierung →
Segmentierung der Fassungsvorderteile
→ Optimierung →
Deformation Fassungsvorderteile

Nachbearbeitung/Glättung der Deformation

Fig.10

EP 3 809 304 A1

Fig.11

Fassungshersteller erstellt parametrisierbares CAD-Modell einer Brillenfassung in proprietärem CAD-System und Satz von veränderbaren Fassungsparametern

↓

Erstellung von Kollektion von Instanzen des parametrisierbaren Modells für bestimmte Wertetupel der veränderbaren Fassungsparameter

↓

Berechnung eines Ersatzmodells der Brillenfassung in einem Analysesystem; Eingabe ist die Kollektion von Modellinstanzen

↓

Ablegen des Ersatzmodells in einer Datenbank

↓

Für jedes Modell Ermittlung einer Darstellung

3D-Messsystem erstellt Kopfmodell — 48

Kunde wählt aus einer Menge von Fassungsmodellen ein Modell aus — 49

↓

Anpassung der Fassung für Kunden mittels Berechnung der optimalen Fassungsparameter — 50

↓

Berechnung des 3D-Meshs der Fassung für gegebene Fassungsparameter

↓

Virtuelles Aufsetzen und Rendering — 52

↓

Gegebenenfalls Optimierung der Anpassung von Fassungsparametern und der Positionierung

↓

Auswahl der Fassung und Übergabe an Bestellsystem

Fig.12

Fig.13

Fig.14

Fig.15

Fig.16

Fig.17A

EP 3 809 304 A1

Fig.17B

Fig.17C

Fig.18A

EP 3 809 304 A1

Fig.18B

EP 3 809 304 A1

Fig.19

Fig.20

EP 3 809 304 A1

Fig.21A

EP 3 809 304 A1

Fig.21B

Fig.21C

Fig.22A

Fig.22B

Fig.22C

Fig.23

EP 3 809 304 A1

Fig.24A

Fig.24B

Fig.24C

**Europäisches Patentamt**

**European Patent Office**

**Office européen des brevets**

# EUROPÄISCHER RECHERCHENBERICHT

Nummer der Anmeldung

EP 19 20 4207

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X,D | EP 2 746 838 A1 (SFERED INTELLIGENCE B V [NL]) 25. Juni 2014 (2014-06-25) * das ganze Dokument * * Absatz [0004] * * Absatz [0026] * * Absatz [0030] * * Seite 35 * | 1-15 | INV. G06F30/17 |
| X | CA 3 072 117 A1 (ZEISS CARL AG [DE]; ZEISS CARL VISION INT GMBH [DE]) 10. Januar 2019 (2019-01-10) * das ganze Dokument * * Absatz [0009] * * Absatz [0012] * * Absatz [0023] * * Anspruch 9 * | 1-15 | |
| X | CA 3 065 878 A1 (ZEISS CARL VISION INT GMBH [DE]) 6. Dezember 2018 (2018-12-06) * das ganze Dokument * * Absatz [0006] * * Absatz [0010] * * Absätze [0012], [0013] * * Absatz [0016] * * Absatz [0030] * * Absatz [0037] * * Anspruch 26 * | 1-15 | |
| X | WO 2016/164859 A1 (BESPOKE INC [US]) 13. Oktober 2016 (2016-10-13) * das ganze Dokument * * Absatz [0006] * * Absatz [0057] * * Absatz [0064] * * Absatz [0067] * * Absatz [0070] * | 1-15 | |

**RECHERCHIERTE SACHGEBIETE (IPC)**

G06F

Der vorliegende Recherchenbericht wurde für alle Patentansprüche erstellt

| Recherchenort | Abschlußdatum der Recherche | Prüfer |
|---|---|---|
| München | 28. April 2020 | Wellisch, J |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 19 20 4207

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

28-04-2020

| Im Recherchenbericht angeführtes Patentdokument | Datum der Veröffentlichung | Mitglied(er) der Patentfamilie | Datum der Veröffentlichung |
|---|---|---|---|
| EP 2746838 A1 | 25-06-2014 | EP 2746838 A1<br>NL 2010009 C2 | 25-06-2014<br>23-06-2014 |
| CA 3072117 A1 | 10-01-2019 | CA 3072117 A1<br>CN 111033364 A<br>EP 3425446 A1<br>EP 3649505 A1<br>KR 20200019757 A<br>WO 2019007939 A1 | 10-01-2019<br>17-04-2020<br>09-01-2019<br>13-05-2020<br>24-02-2020<br>10-01-2019 |
| CA 3065878 A1 | 06-12-2018 | CA 3065878 A1<br>CN 110892315 A<br>EP 3410178 A1<br>EP 3631570 A2<br>KR 20200005671 A<br>US 2020103675 A1<br>WO 2018220203 A2 | 06-12-2018<br>17-03-2020<br>05-12-2018<br>08-04-2020<br>15-01-2020<br>02-04-2020<br>06-12-2018 |
| WO 2016164859 A1 | 13-10-2016 | US 2016299360 A1<br>US 2019377201 A1<br>WO 2016164859 A1 | 13-10-2016<br>12-12-2019<br>13-10-2016 |

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2019051243 A1
- US 20160327811 A1
- US 2016336737 A1
- EP 2746838 A1
- EP 3425447 A1
- EP 3425446 A1

**In der Beschreibung aufgeführte Nicht-Patentliteratur**

- CAD Model Creation from Dense Pointclouds: Explicit, Parametric, Free-Form CAD and Re-engineering. **VUKAŠINOVIC, NIKOLA ; DUHOVNIK, JOZE.** Advanced CAD Modeling. Springer-Verlag, 2019, 217-239
- **ALAN M SHIH ; SANKARAPPAN GOPALSAMY ; YASUSHI ITO ; DOUGLAS ROSS ; MARK DILLAVOU ; BHARAT SONI.** *Automatic and Parametric Mesh Generation Approach,* 2005
- **MAKOTO ONODERA ; ICHIRO NISHIGAKI ; YOSHIMITSU HIRO ; CHIKARA KONGO.** Development of Parametric Mesh Morphing Techniques. *Transactions of the Japan Society of Mechanical Engineers,* 2008, vol. 74, 1894-1600
- *Types of Meshes,* 11. Juli 2019, https://en.wikipedia.org/wiki/Types
- **N. ASPERT ; D. SANTA-CRUZ ; T. EBRAHIMI ; MESH.** Measuring Errors between Surfaces using the Hausdorff Distance. *Proceedings IEEE International Conference on Multimedia and Expo Lausanne,* 2002, 1-4
- A Survey on Mesh Segmentation Techniques. **ARIEL SHAMIR.** Computer Graphics Forum. 2008, vol. 27, 1839-1856
- **BARBARA G. TABACHNICK ; LINDA S. FIDELL ; JODIE B. ULLMAN.** Using Multivariate Statistics. Pearson Verlag, 2007
- **OSCAR KIN-CHUNG AU ; CHIEW-LAN TAI ; HUNG-KUO CHU ; DANIEL COHEN-OR ; TONG-YEE LEE.** Skeleton Extraction by Mesh Contraction. *Proceedings of SIGGRAPH,* 2008

- **SZYMON RUSINKIEWICZ ; MARC LEVOY.** Efficient Variants of the ICP Algorithm,. *Proceedings of the 3DIM Conference,* 2001, 145-182
- **MICHAEL KAZHDAN ; MATTHEW BOLITHO ; HUGUES HOPPE.** Poisson Surface Reconstruction. *Proceedings of the fourth Eurographics symposium on Geometry processing,* 2006
- **MARC LAVIELLE.** Using penalized contrasts for the change-point problem. *Signal Processing,* 2005, vol. 85, 1801-1810
- **S. RUSINKIEWICZ ; M. LEVOY.** *Effcient variants of the ICP algorithm, Proceedings of the Third International Conference on 3-D Digital Imaging and Modeling,* 2001, 145-182
- **PAUL J. BESL ; NEIL D.MCKAY.** A Method for Registration of 3-D Shapes, IEEE Transactions on Pattern Analysis and Machine Intelligence. 1992, vol. 14
- **KOK-LIM LOW.** Linear Least-Squares Optimization for Point-to-Plane ICP Surface Registration. Department of Computer Science University of North Carolina at Chapel Hill, Februar 2004
- **O SORKINE ; D. COHEN-OR.** Laplacian Surface Editing. *Eurographics Symposium on Geometry Processing,* 2004
- **YIZHOU YU et al.** Mesh Editing with Poisson-Based Gradient Field Manipulation. ACM SIGGRAPH, 2004
- **DELTA MUSH ; JOE MANCEWICZ ; MATT L. DERKSEN ; HANS RIJPKEMA ; CYRUS A. WILSON.** Smoothing Deformations while Preserving Detail. *Proceedings oft he 4th Symposium on Digital Production,* 2014